# EUROPÄISCHE PATENTSCHRIFT

(11) **EP 3 918 885 B1**
(45) Veröffentlichungstag und Bekanntmachung des Hinweises auf die Patenterteilung: **17.09.2025**
(21) Anmeldenummer: 20703960.3
(22) Anmeldetag: 31.01.2020
(51) Int. Cl.: H05K 3/46, H01L 23/14, H01L 23/538, H05K 1/18

(54) **TRÄGERANORDNUNG UND VERFAHREN ZUR HERSTELLUNG EINER TRÄGERANORDNUNG**
SUPPORT ASSEMBLY AND METHOD FOR PRODUCING A SUPPORT ASSEMBLY
SYSTÈME SUPPORT ET PROCÉDÉ DE FABRICATION D'UN SYSTÈME SUPPORT

(30) Priorität: 31.01.2019 DE 102019201281
(43) Veröffentlichungstag der Anmeldung: 08.12.2021
(73) Patentinhaber: Fraunhofer-Gesellschaft zur Förderung der angewandten Forschung e.V., 80686 München (DE)
(72) Erfinder: BÖTTCHER, Mathias, 01468 Moritzburg (DE); WINDRICH, Frank, 01468 Moritzburg (DE); ZOSCHKE, Kai, 13355 Berlin (DE); WOLF, M. Jürgen, 01468 Moritzburg (DE)
(74) Vertreter: Pfenning, Meinig & Partner mbB
(86) Internationale Anmeldenummer: PCT/EP2020/052491
(87) Internationale Veröffentlichungsnummer: WO 2020/157314

(56) Entgegenhaltungen:
- DE-A1- 102008 028 300
- US-A1- 2007 215 378
- US-A1- 2008 137 317
- CHOW E M ET AL: "Wafer-Level Packaging With Soldered Stress-Engineered Micro-Springs", IEEE TRANSACTIONS ON ADVANCED PACKAGING, IEEE SERVICE CENTER, PISCATAWAY, NJ, USA, vol. 32, no. 2, 1 May 2009 (2009-05-01), pages 372 - 378, XP011346245, ISSN: 1521-3323, DOI: 10.1109/TADVP.2008.2010507

## Beschreibung

Die Erfindung betrifft eine Trägeranordnung sowie ein Herstellungsverfahren für eine Trägeranordnung. Die Erfindung betrifft insbesondere Trägeranordnungen für Mikrosysteme.

Eine Trägeranordnung der hier beschriebenen Art kann beispielsweise ein Mikrosystem oder ein Teil eines Mikrosystems sein und beispielsweise für mikroelektronische, mikromechanische, mikrofluidische und/oder elektro-optische Anwendungen ausgestaltet sein. Die Trägeranordnung weist mindestens einen Träger auf, beispielsweise ein Substrat aus Silizium oder einem anderen geeigneten Material, auf dem Schnittstellen und/oder Leitungen zur Signalübertragen zwischen mikroelektronischen, mikromechanischen, mikrofluidischen und/oder mikro-optische Bauteilen angeordnet sein können. Die Trägeranordnung kann derartige Bauteile beispielsweise mechanisch miteinander verbinden und/oder selbst derartige Baugruppen oder Bauteile aufweisen. Typischerweise weist die Trägeranordnung Bereiche auf, die sich in ihrer Flexibilität voneinander unterscheiden.

Aus der Leiterplattentechnik sind beispielsweise Trägeranordnungen bekannt, bei denen auf einem relativ starren Träger eine oder mehrere flexible Folien angeordnet sind, die insbesondere als Verbindungsleitungen zu Unterbaugruppen, Sensoren oder Steckverbindern genutzt werden. Typischerweise werden hierfür vorbereitete, bereits strukturierte und mit Leitbahnen versehenen flexible Folien in einem Laminatstapel auf dem starren Träger platziert und mit diesem zu einem starr-flexiblen Verbund, häufig auch als Starr-Flex-Verbund bezeichnet, verpresst. Die Leistungsfähigkeit dieser sogenannten Starr-Flex-Technologie entspricht den technischen Möglichkeiten der herkömmlichen Leiterplattentechnik und ist typischerweise auf Leitbahnbreiten von mindestens 50 µm begrenzt.

Ferner sind Herstellungsverfahren für Si-Chips bekannt, bei denen ein Träger aus Silicium zunächst mit der Kontaktseite auf eine Polymerfolie aufgeklebt wird. Mittels Laser- oder Plasmaprozessen werden dann im Bereich der Kontaktstellen Folie und Kleber entfernt, die Oberfläche des Trägers gereinigt und mit einer ganzflächigen Metallisierung versehen, beispielsweise durch Sputtern oder nasschemisch. Im Weiteren wird mittels Fotolithographie das Leitungsmuster auf die Oberfläche übertragen und über bekannte Verfahren die Leitbahnen erzeugt. Dieses Verfahren erlaubt die direkte Kontaktierung von Si-Chips, hat aber den Nachteil, dass einerseits für die Kontaktierung relativ große Bereiche notwendig sind und andererseits durch die Verwendung von Klebern die Temperaturstabilität eingeschränkt sein kann.

Beispielsweise beschreibt die Veröffentlichung CHOW E M ET AL: "Wafer-Level Packaging With Soldered StressEngineered Micro-Springs", IEEE RANSACTIONS ON ADVANCEO PACKAGING, IEEE SERVICE CENTER, PISCATA-WAY, NJ, USA, Bd. 32, Nr. 2, 1. Mai 2009 (2009-05-01), Seiten 372-378, ein Beispiel für ein Herstellungsverfahren für eine Trägeranordnung. Weitere Beispiele sind den Druckschriften DE 10 2008 028300 A1, US 2007/215378 A1, und US 2008/137317 A1 zu entnehmen.

Grundsätzlich stellt sich daher die Aufgabe, die Herstellung von Trägeranordnungen, insbesondere von Trägeranordnungen der oben beschriebenen Art, zu vereinfachen. Das Verfahren sollte möglichst vielseitig hinsichtlich der möglichen geometrischen Ausgestaltung sowie hinsichtlich der funktionalen Eigenschaften der Trägeranordnung sein. Zudem sollten möglichst kompakte Trägeranordnungen herstellbar sein. Erstrebenswert sind beispielsweise auch eine möglichst gute Temperaturbeständigkeit sowie eine möglichst hohe chemische Stabilität der Trägeranordnung.

Zur Lösung der Aufgabe werden erfindungsgemäß ein Herstellungsverfahren gemäß dem Hauptanspruch sowie eine Trägeranordnung gemäß dem nebengeordneten Patentanspruch sowie ferner auch ein Mikrosystem mit einer solchen Trägeranordnung vorgeschlagen. Weiterentwicklungen und spezielle Ausführungsformen ergeben sich aus den abhängigen Ansprüchen sowie aus der vorangehenden und nachfolgenden Beschreibung und den Figuren. Beispielsweise kann die vorgeschlagene Trägeranordnung und das vorgeschlagene Mikrosystem durch Anwendung des hier vorgeschlagenen Herstellungsverfahrens hergestellt worden sein. Insbesondere lassen sich daher alle im Zusammenhang mit dem Verfahren beschriebenen Merkmale entsprechend auch auf die Trägeranordnung und das Mikrosystem übertragen. Umgekehrt lassen sich entsprechend auch alle im Zusammenhang mit der Trägeranordnung oder dem Mikrosystem beschriebenen Merkmale auf das Herstellungsverfahren übertragen.

Das hier vorgeschlagene Verfahren zum Herstellen einer Trägeranordnung umfasst insbesondere die folgenden Schritte:
- Herstellen mindestens einer Schicht auf einer Oberfläche mindestens eines Trägers, wobei die mindestens eine Schicht mindestens einen ersten Bereich und mindestens einen mit dem mindestens einen ersten Bereich zusammenhängenden zweiten Bereich umfasst, wobei der mindestens eine erste Bereich mindestens einen ersten Oberflächenbereich des mindestens einen Trägers und der mindestens eine zweite Bereich mindestens einen zweiten Oberflächenbereich des mindestens einen Trägers abdeckt,
- vollständiges oder zumindest teilweises Ablösen oder Freistellen des mindestens einen zweiten Bereichs der mindestens einen Schicht von dem mindestens einen Träger. Beispielsweise wird der mindestens eine zweite Bereich der mindestens einen Schicht von dem mindestens einen zweiten Oberflächenbereich des mindestens einen Trägers abgelöst. Es verbleibt jedoch der mindestens eine erste Bereich der Schicht auf dem mindestens einen ersten Oberflächenbereich des Trägers und wird nicht von dem mindestens einen zweiten Bereich der Schicht getrennt.

Das Ablösen kann beispielsweise mechanisch erfolgen, indem beispielsweise der zweite Bereich der Schicht ganz oder teilweise vom Träger abgezogen wird. Zusätzlich oder alternativ kann das Ablösen bzw. Freistellen des zweiten Bereichs der Schicht chemisch erfolgen, indem beispielsweise der Träger lokal durch Ätzen entfernt wird, beispielsweise zumindest diejenigen Bereiche des Trägers, die den zweiten Oberflächenbereich des Trägers bilden. Zusätzlich oder alternativ kann das Ablösen mittels elektromagnetischer Strahlung erfolgen, indem beispielsweise ein Kontaktbereich, auch als Haftungsbereich, Haftungsinterface oder Bondinterface bezeichnet, zwischen dem zweiten Bereich der Schicht und dem zweiten Oberflächenbereich des Trägers mittels elektromagnetischer Strahlung, beispielsweise Laserstrahlung, bestrahlt wird und hierbei beispielsweise ganz oder teilweise zerstört wird. Natürlich sind auch beliebige Kombinationen dieser Ablöseverfahren möglich, so dass beispielsweise ein zweiter Bereich der Schicht mechanisch vom Träger abgelöst wird, ein anderer zweiter Bereich der Schicht chemisch durch Ätzen vom Träger abgelöst wird und noch ein anderer zweiter Bereich der Schicht mittels Bestrahlung vom Träger abgelöst wird. Ist auch möglich, dass ein zweiter Bereich der Schicht zunächst teilweise mittels elektromagnetischer Strahlung abgelöst wird und anschließend vollständig mechanisch abgelöst (z.B. abgezogen) wird.

Die mindestens eine Schicht ist zumindest innerhalb des abgelösten mindestens einen zweiten Bereichs flexibel, also biegsam und beispielsweise auch dehnbar. Beispielsweise ist es also möglich, die mindestens eine Schicht innerhalb des abgelösten mindestens einen zweiten Bereich zu biegen, zu falten, und/oder zu dehnen, ohne die Schicht hierdurch zu beschädigen.

Entsprechend dem Herstellungsverfahren umfasst die hier vorgeschlagene Trägeranordnung:
- mindestens einen Träger mit (jeweils) einer Oberfläche und- mindestens eine Schicht mit mindestens einem ersten Bereich, der auf der Oberfläche des mindestens einen Trägers angeordnet ist, und mindestens einen zweiten Bereich, der mit dem mindestens einen ersten Bereich zusammenhängt und nicht auf der Oberfläche des mindestens einen Trägers angeordnet ist. Wie oben bereits beschrieben worden ist, ist die Schicht in dem mindestens einen (abgelösten) zweiten Bereich flexibel, also biegsam und beispielsweise auch dehnbar.

Vorzugsweise ist die Trägeranordnung unter Anwendung des hier vorgeschlagenen Verfahrens hergestellt worden. Die Oberfläche des mindestens einen Trägers umfasst dann den oben im Zusammenhang mit dem Verfahren definierten mindestens einen ersten Oberflächenbereich und der mindestens eine erste Bereich der mindestens einen Schicht ist auf dem ersten Oberflächenbereich angeordnet.

Das vorgeschlagene Mikrosystem umfasst mindestens eine Trägeranordnung hier vorgeschlagener Art sowie mindestens ein Bauteil, wie beispielweise mindestens ein mikroelektronisches, mikromechanisches, mikrofluidisches und/oder elektro-optisches Bauteil. Auf dem mindestens einen Träger der mindestens einen Trägeranordnung sind beispielsweise Kontaktelemente und/oder Leitungen angeordnet, die zur Signalübertragen mit dem Bauteil bzw. zwischen den Bauteilen eingerichtet sind. Das mindestens eine Bauteil kann beispielsweise auf der Oberfläche des mindestens einen Trägers angeordnet sein, insbesondere auf dem ersten Oberflächenbereich, dem zweiten Oberflächenbereich oder einem hieran angrenzenden weiteren Oberflächenbereich des Trägers. Außerdem kann mindestens ein Bauteil auf der mindestens einen Schicht angeordnet sein oder in die mindestens einen Schicht der mindestens einen Trägeranordnung integriert sein, insbesondere in dem ersten Bereich oder in dem von dem jeweiligen Träger abgelösten flexiblen zweiten Bereich. Weitere Beispiele für Bauteile, Leitungen und Kontakteelemente werden weiter unten angegeben.

Als Synonym zum Begriff des Trägers wird auch der Begriff des Substrats verwendet. Zudem wird der Träger auch als Trägerelement bezeichnet. Teile bzw. Segmente des Trägers können ihrerseits ebenfalls als Träger bezeichnet werden. Die oben verwendete Formulierung "mindestens ein(e)" hat die übliche Bedeutung von "ein(e) oder mehr als ein(e)". Lediglich der besseren Lesbarkeit halber wird im Folgenden auf die Formulierung "mindestens eine(n)" (insbesondere im Zusammenhang mit dem Träger, der Schicht, dem ersten und zweiten Bereich der Schicht und dem ersten und zweiten Oberflächenbereich des Trägers) verzichtet. Somit ist "ein(e)" jeweils als "mindestens ein(e)" zu lesen und entsprechend "der" oder "die" jeweils als "der mindestens eine" bzw. "die mindestens eine". Beispielsweise kann bei dem Herstellungsverfahren die mindestens eine Schicht auf der Oberfläche genau eines Trägers (Substrats) hergestellt werden. Wie weiter unten näher beschrieben wird, kann der Träger nachfolgend in Segmente zerteilt werden (ohne hierbei den ersten Bereich der Schicht von dem zweiten Bereich der Schicht zu trennen), sodass die so hergestellte Trägeranordnung mehrere Trägersegmente, also mehrere Träger, umfasst. Diese Trägersegmente sind dann typischerweise durch die (nicht oder zumindest nicht vollständig durchtrennte) Schicht miteinander verbunden.

Typischerweise ist die genannte Oberfläche des Trägers eben und definiert somit eine Hauptebene des Trägers. Der erste Oberflächenbereich grenzt typischerweise an den zweiten Oberflächenbereich des Trägers an. Im Falle mehrerer erster Oberflächenbereiche und/oder mehrere zweiter Oberflächenbereiche grenzt jeder zweiter Oberflächenbereich typischerweise an mindestens einen (der) ersten Oberflächenbereich(e) an.

Bei der Trägeranordnung handelt es sich beispielsweise um ein starr-flexibles System, umfasst also starre Bereichen sowie flexible (biegsame und/oder dehnbare) Bereiche. Beispielsweise kann der Träger starr (also mechanisch stabil und nicht oder kaum biegsam oder dehnbar) sein und die Schicht zumindest in dem abgelösten zweiten Bereich flexibel sein. Wie weiter unten beschrieben wird, ist es aber auch möglich, dass der Träger halb-starr oder flexibel ist, beispielsweise also biegsam und/oder dehnbar ist, beispielsweise aufgrund einer nur geringen Dicke des Trägers. Typischerweise ist die Schicht im abgelösten zweiten Bereich aber flexibler, also insbesondere biegsamer und/oder dehnbarer, als der Träger.

Die Schicht kann beispielsweise in Form einer (dünnen) Folie oder eines (dünnen) Films ausgestaltet sein. Die Schicht kann beispielsweise eine Gesamtdicke zwischen 1 und 300 µm aufweisen. Vorzugsweise liegt die Gesamtdicke der Schicht zwischen 1 und 100 µm und besonders bevorzugt zwischen 1 und 50 µm. Vorzugsweise wird die Schicht mittels Dünnfilmtechniken und/oder lithografischer Verfahren hergestellt bzw. strukturiert, wie beispielsweise mittels PVD, CVD, Fotolithografie, Laserablation oder anderen Verfahren, wie weiter unten ausführlicher beschrieben wird.

In einem Beispiel wird (unter Ausnutzung der Flexibilität oder Biegsamkeit der Schicht im abgelösten zweiten Bereich) die Schicht innerhalb des abgelösten zweiten Bereichs gebogen oder gefaltet. Durch das Biegen oder Falten wird eine Krümmung der Schicht in dem abgelösten zweiten Bereichs der Schicht erzeugt, der beispielsweise einen Biegeradius von minimal 50 µm aufweist, typischerweise in einem Bereich zwischen 50 µm und 40 mm. Die Schicht kann somit beispielsweise eine bereichsweise nicht-ebene Form annehmen und einen gekrümmten Bereich aufweisen. Durch das Biegen bzw. Falten der Schicht im abgelösten zweiten Bereich kann der zweite Bereich der Schicht beispielsweise aus der oben erwähnten Hauptebene des Trägers heraus bewegt werden. Beispielsweise kann eine von dem zweiten Bereich der Schicht definierte Ebene mit einer durch die Oberfläche des Trägers definierte Ebene einen nicht-verschwindenden Winkel einschließen. Der Winkel kann beispielsweise in einem Bereich zwischen 0° und 180° liegen, beispielsweise zwischen 85° und 95°. Es sind zudem auch Verdrehungen (Torsionen) des abgelösten zweiten Bereichs der Schicht möglich.

Die Schicht kann ganz oder zumindest bereichsweise eine aus einem Polymer, beispielsweise aus Polyimid oder Polybenzoxazol, aus einem Metall, aus Glas, Keramik oder aus Silizium oder aus einer Kombination von zwei oder mehr dieser Materialien gebildet sein. Um die genannte Flexibilität, insbesondere Biegsamkeit und/oder Dehnbarkeit, der Schicht zu erzielen, wird die Schicht typischerweise aus entsprechend flexiblen Materialien gebildet. Es ist aber auch möglich, die Schicht aus relativ starren oder spröden Materialien zu bilden (wie etwa Metall, Glas, Keramik oder Silizium) oder solche Materialien in die Schicht zu integrieren. Hierbei muss aber typischerweise gewährleistet werden, dass die Schicht eine hinreichend kleine Gesamtdicke aufweist oder dass diese relativ starren oder spröden Materialen nur einen hinreichend kleinen Teil der Gesamtdicke bilden.

Der Träger kann beispielsweise ganz oder zumindest bereichsweise aus Silizium, Glas, Metall, Keramik oder einem Polymer oder aus einer Kombination von zwei oder mehr dieser Materialien gebildet sein. Beispielsweise kann es sich bei dem Träger um einen Wafer, insbesondere einen Silicium-Wafer, oder einen Teil eines (Silicium-)Wafers, um eine Platte, wie beispielsweise eine Glasplatte oder ein Glaspanel, oder um ein Band handeln, beispielsweise ein Band aus einem Polymer oder einem Verbundwerkstoff.

Der Träger ist typischerweise starrer und daher weniger flexibel und weniger biegsam als die Schicht im abgelösten zweiten Bereich. Durch Biegen des Trägers erreichbare Biegeradien des Trägers liegen daher (je nach Starrheit des Trägers) typischerweise oberhalb 50 mm oder sogar oberhalb von 250 mm. Wie oben bereits erwähnt worden ist, ist es beispielsweise auch möglich, dass auch der Träger relativ flexibel und biegsam ist. Um dies zu erreichen, kann der Träger entsprechend dünn ausgestaltet sein, insbesondere wenn er aus einem relativ starren oder spröden Material gebildet ist. Beispielsweise kann daher die Gesamtdicke des Trägers zwischen 10 und 2000 µm, zwischen 10 und 800 µm oder zwischen 10 und 300 µm sein.

Die Schicht kann mehrlagig sein oder mehrere übereinander angeordnete Schichten bzw. Teilschichten der Schicht umfassen, welche in dem abgelösten zweiten Bereich beispielsweise einen flexiblen (biegsamen) Verbund bilden können. Vorzugsweise wird zumindest eine oder mehrere der Teilschichten mittels Dünnfilmtechniken und/oder lithografischer Verfahren hergestellt.

Bei den Schichten bzw. Teilschichten der Schicht kann es sich beispielsweise um Isolationsschichten und/oder um Leitungsschichten handeln, beispielsweise um elektrische, optische und/oder mikrofluidische Isolationsschichten und/oder um elektrische, optische und/oder mikrofluidische Leitungsschichten. Die Isolations- und Leitungsschichten sind beispielsweise alternierend übereinader geschichtet. Beispielsweise umfasst die Leitungsschicht mindestens eine Leitung, beispielsweise mindestens eine aus einem elektrisch leitendenden Material gebildete Leiterbahn, mindestens einen optischen Leiter und/oder mindestens einen mikrofluidischen Kanal.

In einem Beispiel wird beim Herstellen der Schicht auf der Oberfläche des Trägers beispielsweise mindestens eine (elektrische) Isolationsschicht der Schicht aus einem (elektrisch) isolierenden Material (Dielektrikum) gebildet, wie beispielsweise aus einem der weitere unten beschriebenen Polymere, insbesondere Polyimide (PI) und Polybenzoxazole (PBO). Die mindestens eine Isolationsschicht kann beispielsweise zumindest den ersten Oberflächenbereich und den zweiten Oberflächenbereich des Trägers abdecken. Auf der mindestens einen Isolationsschicht wird beispielsweise eine Leitungsschicht gebildet, beispielsweise aus einem elektrisch leitendenden Material. Als elektrisch leitende Materialien kommen beispielsweise Metalle, wie beispielsweise Kupfer (Cu), Aluminium (Al), Titan (Ti) und Gold (Au). Beispielsweise umfasst die mindestens eine Leitungsschicht mindestens eine durchgängige Leitung oder Leiterbahn, die sich ausgehend von dem ersten Bereich der Schicht bis in den zweiten Bereich der Schicht erstreckt. Bei der Schicht kann es sich also beispielsweise um eine (mehrlagige) Umverdrahtungsschicht oder Umverdrahtungsfolie handeln.

Beispielsweise kann der von dem Träger bzw. dem zweiten Oberflächenbereich des Trägers abgelöste zweite Bereich mit einem weiteren Träger der Trägeranordnung verbunden sein oder verbunden werden. Dieser weitere Träger kann beispielsweise wie der erstgenannte Träger gestaltet sein, also beispielsweise ebenfalls starr sein. Die für den erstgenannten Träger beschriebenen Ausführungsbeispiele gelten genauso auch für den hier genannten weiteren Träger. Der weitere Träger weist typischerweise ebenfalls eine Oberfläche auf, die beispielsweise eben ausgestaltet sein kann, und mit der der abgelöste zweite Bereich der Schicht beispielsweise flächig und/oder mittels mechanischen Verbindungselementen oder den bereits genannten Kontaktelementen verbunden werden kann. Diese Verbindung kann beispielsweise kraftschlüssig oder stoffschlüssig, beispielsweise mittels Lotverbindungen, erfolgen. Die mechanischen Verbindungselemente können beispielsweise durch sogenannte Micro-Kontaktelemente oder Micro-Lotbumps, Bonddrähte oder Steckverbindungselementen sein.

Außerdem ist es möglich, dass, bevor oder nachdem der zweite Bereich der Schicht von dem zweiten Oberflächenbereich des Trägers abgelöst wird, der Träger in dem zweiten Oberflächenbereich oder zwischen dem ersten Oberflächenbereich und dem zweiten Oberflächenbereich durchtrennt wird, beispielsweise entlang einer Schnittebene. Typischerweise wird hierbei aber nicht die Schicht durchtrennt. Insbesondere wird durch das Durchtrennen des Trägers der ersten Bereich und der zweiten Bereich der Schicht typischerweise nicht voneinander getrennt, sondern bleiben weiterhin miteinander zusammenhängend.

Beispielsweise ist es möglich, den Träger zweimal oder mehrfach zu durchtrennen, beispielsweise in dem zweiten Oberflächenbereich oder zwischen dem mindestens einen ersten Oberflächenbereich und dem mindestens einen zweiten Oberflächenbereich des Trägers. Auf diese Weise kann der Träger in zwei, drei oder mehr Teile oder Segmente zerteilt werden. Beispielsweise können genau ein erster Oberflächenbereich und genau ein zweiter Oberflächenbereich des Trägers vorgesehen sein. In diesem Fall wird der Träger typischerweise in genau zwei Teile oder Segmente zerlegt und die Schicht dann typischerweise von demjenigen Segment abgelöst, welches den zweiten Oberflächenbereich (oder einen Teil des zweiten Oberflächenbereich) bildet. Es können aber beispielsweise auch zwei erste Oberflächenbereiche und ein dazwischen liegender zweiter Oberflächenbereich vorgesehen sein. In diesem Fall wird der Träger durch das beschriebene Durchtrennen beispielsweise innerhalb des zweiten Oberflächenbereichs oder jeweils zwischen dem zweiten Oberflächenbereich und den beiden ersten Oberflächenbereichen durchtrennt, so dass der Träger beispielsweise in drei Segmente zerteilt wird, beispielsweise in ein mittleres Segment und zwei äußere Segmente. Beispielsweise werden die beiden ersten Oberflächenbereiche jeweils durch einen der beiden äußeren Segmente gebildet und der zweite Oberflächenbereich durch das mittlere Segment. Die Schicht (d. h. ihr zweiter Bereich) wird dann beispielsweise von dem mittleren Segment vollständig abgelöst (und möglicherweise auch teilweise noch von den beiden äußeren Segmenten). Das mittlere Segment wird anschließend typischerweise von der Trägeranordnung entfernt. Die Schicht (d. h. ihre beiden ersten Bereiche) verbleibt auf den beiden ersten Oberflächenbereichen der beiden äußeren Segmente des Trägers. Der abgelöste zweite Bereich bildet dann eine flexible Verbindung zwischen den beiden verbliebenden äußeren Segmenten des Trägers.

Das oben beschriebene Durchtrennen des Trägers kann beispielsweise entlang zwei oder mehr Schnittebenen erfolgen. Die Schnittebenen können jeweils senkrecht zur oben genannten Hauptebene des Trägers verlaufen oder aber einen von 90° verschiedenen Winkel einschließen. Der Winkel kann beispielsweise in einem Bereich zwischen 45° und 135° liegen, beispielsweise bei etwa 90°.

Beispielsweise kann der zweite Bereich der Schicht von dem zweiten Oberflächenbereich des Trägers abgelöst werden, indem ein Bereich des Trägers, der den ersten Oberflächenbereich des Trägers bildet (beispielsweise das oben beschriebene mittlere Segment des Trägers), durch Ätzen entfernt wird. Entsprechende Ausführungsbeispiele für Ätzverfahren werden weiter unten ausführlich beschrieben.

Beispielsweise kann, bevor der zweite Bereich der Schicht von dem zweiten Oberflächenbereich des Trägers abgelöst wird, die Haftung des zweiten Bereichs der Schicht auf dem zweiten Oberflächenbereich ganz oder bereichsweise zerstört oder zumindest reduziert werden. Hierdurch kann eine vollständige Ablösung des zweiten Bereichs der Schicht vom Träger erreicht werden oder die nachfolgende mechanische Ablösung (bspw. durch Abziehen) vereinfacht werden. Beispielsweise kann der zweite Oberflächenbereich des Trägers mit elektromagnetischer Strahlung bestrahlt werden. Beispielsweise kann die Bestrahlung durch den Träger hindurch erfolgen. Zu diesem Zweck kann der Träger beispielsweise aus einem für die gewählte Strahlung (Wellenlänge) transparenten Material gebildet sein. Zusätzlich oder alternativ kann auch der auf dem zweiten Oberflächenbereich haftende zweite Bereich der Schicht mit elektromagnetischer Strahlung bestrahlt werden.

Um das Ablösen zu erleichtern, wird zusätzlich oder alternativ vor dem Herstellen der Schicht auf der Oberfläche des Trägers auf den zweiten Oberflächenbereich des Trägers eine haftkraftreduzierende Zwischenschicht hergestellt. Hierbei wird zumindest der erste Oberflächenbereich des Trägers ausgespart oder die haftkraftreduzierende Zwischenschicht wird von dem ersten Oberflächenbereich des Trägers wieder entfernt, bevor die Schicht auf der Oberfläche des Trägers hergestellt wird.

Zusätzlich ist es auch möglich, eine haftkraftreduzierende Zwischenschicht auf einer Teilschicht der Schicht aufzutragen und anschließend auf dieser haftkraftreduzierende Zwischenschicht eine oder mehrere weitere der genannten Teilschichten der Schicht herzustellen. Anschließend können diese weiteren Teilschichten beispielsweise von der (auf diese Weise in die Schicht integrierten bzw. eingebetteten) Zwischenschicht und somit auch vom Träger abgelöst (beispielsweise abgezogen) werden, ohne diesen abgelösten (zweiten) Bereich der Schicht von dem Rest der Schicht (dem ersten Bereich der Schicht) zu trennen.

Zusätzlich oder alternativ zur haftkraftreduzierenden Zwischenschicht wird vor dem Herstellen der Schicht auf der Oberfläche des Trägers auf den ersten Oberflächenbereich des Trägers eine Haftkraft verstärkende Zwischenschicht aufgebracht wird. Beim Aufbringen der die Haftkraft verstärkenden Zwischenschicht wird der zweite Oberflächenbereich ausgespart oder die haftkraftverstärkende Zwischenschicht wird von dem zweiten Oberflächenbereich des Trägers wieder entfernt, bevor die Schicht auf der Oberfläche des Trägers hergestellt wird.

Die Haftkraft reduzierende oder verstärkende Zwischenschicht kann, wie weite unten ausführlicher beschrieben wird, beispielsweise mit Dünnfilmtechniken und/oder lithografischen Verfahren hergestellt und/oder strukturiert werden. Erfindungsgemäß ist die jeweilige Haftkraft verstärkende oder Haftkraft reduzierende Zwischenschicht ein Monolayer (eine Monolage), also eine Schicht aus nur einer Lage der Atome oder der Moleküle des Materials der haftkraftverstärkende bzw. haftkraftreduzierenden Zwischenschicht.

Auf dem Träger, beispielsweise auf der Oberfläche des Trägers, beispielsweise innerhalb des ersten Oberflächenbereichs, kann beispielsweise mindestens ein Kontaktelement, beispielsweise ein elektrisches, optisches und/oder mikrofluidisches Kontaktelement, angeordnet sein bzw. angeordnet werden. Beispielsweise kann das Kontaktelement ausgehend von dem ersten Oberflächenbereich des Trägers den Träger in seiner Dicke und/oder den ersten Bereich der Schicht in seiner Dicke teilweise oder vollständig durchlaufen. Beispielsweise kann zwischen dem mindestens einen (elektrischen, optischen und/oder mikrofluidischen) Kontaktelement und einer (elektrischen, optischen und/oder mikrofluidischen) Leitung der Schicht (beispielsweise einer der oben genannten Leitungen) mindestens eine (elektrische, optische und/oder mikrofluidische) Verbindung hergestellt werden. Außerdem ist es möglich, dass das Kontaktelement mit einer auf dem Träger angeordneten elektrischen, optischen und/oder mikrofluidischen Leitung und/oder mit einem auf dem Träger angeordneten elektrischen, optischen und/oder mikrofluidischen Bauteil elektrisch, optisch und/oder mikrofluidisch leitend verbunden wird.

Mögliche Beispiele für Bauteile sind unter anderem integrierte Schaltungen, Mikrochips, wie beispielsweise CMOS Chips, CPUs oder Datenspeicher sowie außerdem Energiespeicher, MEMS, MOEMS, Widerstände, Antennen, Spulen, Kondensatoren, Sensoren und Aktuatoren. Als Kontaktelemente kommen beispielsweise Vias, Durchkontaktierungen wie beispielsweise TSVs, Kontaktleisten, Lotkontakte, Außenkontakte für Steckverbindungen, Steckerleisten, Drahtbond-Pads, Kontaktpads, beispielsweise für Thermokompressions-Verbindungen, in Frage.

Wie bereits oben erwähnt gelten alle für den Träger beispielsweise angegebenen Merkmale und Ausführungsbeispiele entsprechend auch für weitere Träger der Trägeranordnung, sofern vorhanden. So ist es beispielweise möglich, dass auf der Oberfläche des weiteren Trägers mindestens ein (weiteres) elektrisches, optisches und/oder mikrofluidisches Kontaktelement angeordnet ist. Beispielsweise kann zwischen dem (weiteren) mindestens einen elektrischen, optischen und/oder mikrofluidischen Kontaktelement und einer Leitung der Schicht mindestens eine elektrische, optische und/oder mikrofluidische Verbindung hergestellt werden. Das Kontaktelement kann beispielsweise außerdem mit einer auf dem weiteren Träger angeordneten elektrischen, optischen und/oder mikrofluidischen Leitung und/oder mit einem auf dem weiteren Träger angeordneten elektrischen, optischen und/oder mikrofluidischen Bauteil leitend verbunden werden.

Beispielsweise kann auch die Schicht selbst mit mindestens einem (elektrischen, optischen und/oder mikrofluidischen) Bauteil und/oder einem (elektrischen, optischen und/oder mikrofluidischen) Kontaktelement ausgestattet sein bzw. werden. Beispielsweise kann das mindestens eine Bauteil und/oder das Kontaktelement auf der Schicht angeordnet werden oder in die Schicht integriert werden, beispielsweise in dem ersten Bereich der Schicht oder in dem zweiten Bereich der Schicht. Es können aber auch beide Bereiche der Schicht mit Bauteilen ausgestattet werden. Als Bauteile und Kontaktelemente kommen beispielsweise die oben oder weiter unten genannten Beispiele von Bauteilen und Kontaktelemente in Frage.

Sofern vorhanden, wird das mindestens eine Bauteil und/oder das mindestens eine Kontaktelement mit mindestens einer der oben beschriebenen Leitungen auf bzw. in der Schicht verbunden.

Vorzugsweise weist die hier vorgeschlagene bzw. die mit dem hier vorgeschlagenen Verfahren hergestellte Trägeranordnung zwischen der Oberfläche des Trägers und dem ersten Bereich der Schicht keine aus einem Kleber gebildete Schicht auf. Vorzugsweise weist die Trägeranordnung zwischen der Oberfläche des Trägers und dem ersten Bereich der Schicht zumindest keine aus einem Kleber gebildete Schicht auf, die dicker ist als eine Monolage des Materials des Klebers. (Eine Monolage ist eine Schicht bestehend aus nur einer Lage von Atome oder Molekülen des jeweiligen Materials der Schicht.) Durch den Verzicht auf eine Kleberschicht ist es oftmals möglich, die Temperaturbeständigkeit und die chemische Stabilität der Trägeranordnung zu verbessern.

Beispielsweise kann der zweite Bereich der Schicht über einen (seitlichen) Rand des Trägers seitlich hinausragen und hier beispielsweise vom Träger seitlich abstehen. Dieser seitlich über den Träger hinausragende Teil kann beispielsweise freitragend sein oder mit einem weiteren Träger (beispielsweise wie oben beschrieben) verbunden sein. Hierdurch lassen sich beispielsweise sogenannte Fan-Out-Strukturen erzielen. Es ist auch möglich, dass der zweite Bereich der Schicht nicht über einen (seitlichen) Rand des Trägers seitlich hinausragt, sondern oberhalb der Oberfläche des Trägers angeordnet ist, wodurch sich beispielsweise sogenannte Fan-In-Struktur gebildet werden kann.

Die Erfindung wird nachfolgend anhand von konkreten Ausführungsbeispielen näher erläutert, welche in den folgenden Figuren schematisch dargestellt sind. Es zeigen:
- Figur 1A: einen Träger für eine Trägeranordnung hier vorgeschlagener Art in einer Ansicht von oben,
- Figur 1B: den in Figur 1A gezeigten Träger in einer Seitenansicht,
- Figur 2A: den in Figur 1A gezeigten Träger mit einer Teilschicht einer Schicht in einer Ansicht von oben,
- Figur 2B: den in Figur 2A gezeigten Träger mit aufgetragener Teilschicht in einer Seitenansicht,
- Figur 3A: den in Figur 2A gezeigten Träger mit einer weiteren Teilschicht der Schicht in einer Ansicht von oben,
- Figur 3B: den in Figur 3A gezeigten Träger mit weiterer Teilschicht in einer Seitenansicht,
- Figur 4A: eine Trägeranordnung hier vorgeschlagener Art, mit dem in Figur 3A gezeigten Träger in einer Ansicht von oben, nachdem Bereiche des Trägers entfernt worden sind und Bauteile auf vom Träger abgelösten Bereichen der Schicht angeordnet sind,
- Figur 4B: die in Figur 4A gezeigte Trägeranordnung in einer Seitenansicht,
- Figur 5A: ein weiteres Ausführungsbeispiel einer Trägeranordnung hier vorgeschlagener Art in einer Ansicht von oben,
- Figur 5B: die in Figur 5A gezeigte Ausführungsbeispiel in einer Seitenansicht,
- Figur 6A: ein weiteres Ausführungsbeispiel einer Trägeranordnung hier vorgeschlagener Art in einer Ansicht von oben,
- Figur 6B: die in Figur 6A gezeigte Ausführungsbeispiel in einer Seitenansicht,
- Figur 7A: ein Beispiel eines Trägers für eine Trägeranordnung hier vorgeschlagener Art in einer Ansicht von oben,
- Figur 7B: den in Figur 7A gezeigten Träger mit einer aufgetragenen Schicht in einer Ansicht von oben mit eingezeichneten Schnittebenen,
- Figur 7C: eine Trägeranordnung hier vorgeschlagener Art in einer Seitenansicht, hergestellt aus dem in Figur 7B gezeigten Träger,
- Figur 7D: eine Variante des in Figur 7C gezeigten Ausführungsbeispiels,
- Figur 8: ein Ausführungsbeispiel einer Trägeranordnung hier vorgeschlagener Art in einer Seitenansicht,
- Figur 9: ein Beispiel eines Trägers für eine Trägeranordnung hier vorgeschlagener Art in einer Ansicht von oben,
- Figur 10A: ein Ausführungsbeispiel einer Trägeranordnung hier vorgeschlagener Art in einer Ansicht von oben, und
- Figur 10B: einen vergrößerter Ausschnitt der in Figur 10A gezeigten Darstellung.

In den Figuren und der nachfolgenden Beschreibung werden einander entsprechende Merkmale mit den gleichen Bezugszeichen bezeichnet oder mit Bezugszeichen, die sich um ganzzahlige Vielfache von 100 voneinander unterscheiden (siehe die Bezugszeichenliste am Ende der Beschreibung).

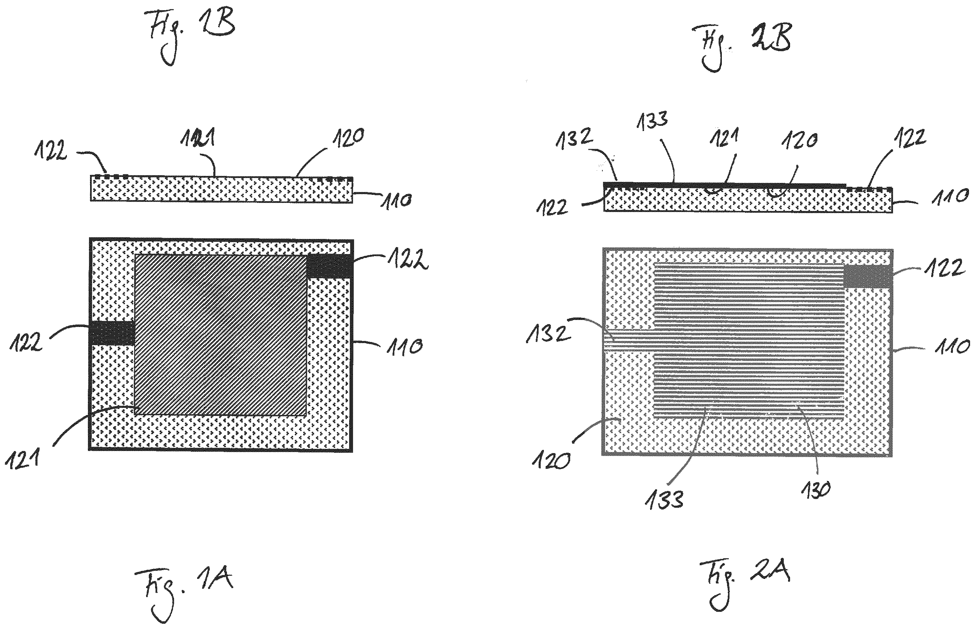

In den Figuren 1A, 1B, 2A, 2B, 3A, 3B, 4A und 4B werden einzelne Schritte eines Ausführungsbeispiels des hier vorgeschlagenen Herstellungsverfahrens gezeigt, bei dem ein Ausführungsbeispiel einer Trägeranordnung 100 hier vorgeschlagene Art hergestellt wird.

In Figuren 1A und 1B ist ein Träger 110 mit einer ebenen Oberfläche 120 gezeigt. Der Träger 110 ist beispielsweise aus Silizium gefertigt, könnte aber auch ganz oder zumindest teilweise aus einem anderen Material gefertigt sein, wie beispielsweise Glas, Metall, Keramik oder einem Polymer oder aus einer Kombination von zwei oder mehr dieser Materialien. Beispielsweise handelt es sich bei dem Träger 110 um einen Wafer oder um einen Teil eines Wafers. Der Träger könnte aber auch eine Platte, wie beispielsweise ein Glaspanel, oder ein Band sein. Der Träger110 kann beispielsweise rund oder rechteckig sein oder eine beliebige andere Form aufweisen.

Der Träger 110 ist relativ starr und somit nur in relativ geringem Umfang biegsam. Beispielsweise liegt eine Gesamtdicke in einem Bereich zwischen 300 µm und 2000µm Beispielsweise hat der Träger eine Gesamtdicke von etwa 800 µm. Durch Biegen des Trägers 110 erreichbare Biegeradien liegen beispielsweise oberhalb von 250 mm.

Es wäre aber prinzipiell auch möglich, dass der Träger 110 flexibel und biegsam ausgestaltet ist. Um dies zu erreichen kann der Träger 110 entsprechend dünn ausgestaltet sein, beispielsweise eine Gesamtdicke in einem Bereich zwischen 10 µm und 300 µm haben, beispielsweise weniger als 200 µm.

In den Figuren 1A und 1B dargestellt sind zudem ein erster Oberflächenbereich 121 des Trägers 110 sowie zwei zweite Oberflächenbereiche 122 des Trägers 110, welche jeweils an den ersten Oberflächenbereich 121 angrenzen.

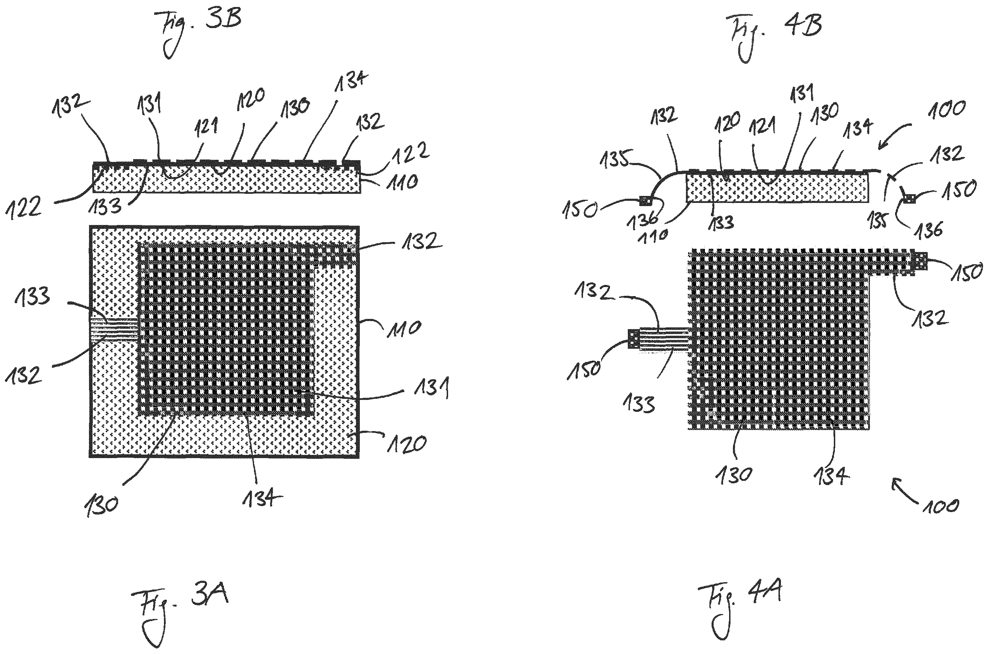

Um das später noch durchzuführende Ablösen der noch auf den Träger 120 aufzutragenden Schicht 130 (siehe Figuren 2A, 2B, 3A und 3B sowie die zugehörige Beschreibung weiter unten) zu erleichtern, sind verschiedene Maßnahmen möglich.

Beispielsweise kann noch vor dem Herstellen der Schicht auf der Oberfläche 120 des Trägers 110 auf den zweiten Oberflächenbereich 122 eine Haftkraft reduzierende Zwischenschicht (nicht dargestellt) aufgebracht werden. Hierbei wird die übrige Oberfläche 120, insbesondere der erste Oberflächenbereich 121 des Trägers vorzugsweise ausgespart. Alternativ ist es auch möglich, dass die Haftkraft reduzierende Zwischenschicht zumindest von dem ersten Oberflächenbereich 121 des Trägers 120 wieder entfernt wird, bevor die Schicht auf der Oberfläche 120 des Trägers 110 hergestellt wird.

Zusätzlich oder alternativ ist es möglich, dass vor dem Herstellen der Schicht 130 auf der Oberfläche 120 des Trägers 110 auf den ersten Oberflächenbereich 121 des Trägers 110 eine haftkraftverstärkende Zwischenschicht (hier nicht dargestellt) aufgebracht wird. Beim Aufbringen der Haftkraft verstärkenden Zwischenschicht kann entsprechend der zweite Oberflächenbereich 122 ausgespart werden. Alternativ ist es auch möglich, dass die haftkraftverstärkende Zwischenschicht von dem zweiten Oberflächenbereich 122 des Trägers 110 wieder entfernt wird, bevor die Schicht auf der Oberfläche des Trägers hergestellt wird.

Die jeweilige Haftkraft verstärkende oder Haftkraft reduzierende Zwischenschicht kann beispielsweise mittels Dünnfilmtechniken und/oder lithografischer Verfahren auf die Oberfläche 120 des Trägers 110 aufgetragen und strukturiert werden. Beispielsweise kann die Zwischenschicht (je nach Bedarf) von den ersten Oberflächenbereich 121 beziehungsweise vom zweiten Oberflächenbereich mittels (O₂)-Plasmaätzen wieder entfernt werden.

Die jeweilige Haftkraft verstärkende oder Haftkraft reduzierende Zwischenschicht ist ein Monolayer (eine Monolage), also eine Schicht aus nur einer Lage der Atome oder der Moleküle des Materials der haftkraftverstärkende bzw. haftkraftreduzierenden Zwischenschicht
Das Material der Haftkraft reduzierenden Zwischenschicht ist typischerweise derart gewählt, dass die noch aufzutragende Schicht 130 auf der Haftkraft reduzierenden Zwischenschicht (im zweiten Oberflächenbereich 122 des Trägers 110) mit einer geringeren Haftkraft haftet als auf dem Material des Trägers 110. Entsprechend ist das Material der Haftkraft verstärkenden Zwischenschicht typischerweise derart gewählt, dass die noch aufzutragende Schicht 130 auf der Haftkraft verstärkenden Zwischenschicht (im ersten Oberflächenbereich 121 des Trägers 110) mit einer größeren Haftkraft haftet als auf dem Material des Trägers 110. Je nach Material des Trägers 110 und Material der Schicht 130 kann durch die Haftkraft reduzierende bzw. verstärkende Zwischenschicht beispielsweise beeinflusst werden, wie hydrophil oder wie hydrophob die ersten und zweiten Oberflächenbereiche des Trägers ist.

Im vorliegenden Beispiel kann die noch aufzubringende Schicht 130 beispielsweise ganz oder zumindest bereichsweise, beispielsweise in Bereichen, die direkt an das Material des Trägers 110 oder an die Haftkraft verstärkende Zwischenschicht oder an die Haftkraft reduzierende Zwischenschicht angrenzen, aus einem Polymer gebildet sein. Beispielsweise kann das Polymer ein Polyimid (PI) oder ein Polybenzoxazol (PBO) oder eine Kombination hiervon beinhalten.

In dem Polymer der Schicht 130 können beispielsweise funktionale Gruppen des Polymers als Haftvermittler integriert sein, beispielsweise sogenannte "Build-In Adhesion Promoter". Diese können beispielsweise die Eigenschaft haben, kovalente Bindungen zum Trägermaterial einzugehen (hier beispielsweise Silicium oder auch Glas). Um beispielsweise die Haftkraft zu reduzieren, kann die Oberfläche 120 des Trägers 110 beispielsweise so verändert werden, dass die kovalenten Bindungen unterdrückt werden oder nicht mehr stabil sind, beispielsweise mittels der genannten Haftkraft reduzierenden Zwischenschicht.

Beispiele für geeignete Polymere (bzw. Polymersysteme) mit integrierten Haftvermittlern für die Schicht 130, insbesondere für dessen Teilschichten 133, 134, sind beispielsweise Polyimide (PI) sowie Polybenzoxazole (PBO) oder Kombinationen hiervon. Unter den Polyimide gibt es beispielsweise folgende kommerzielle Produkte: die LTC9300 Serie und die DUR7300 Serie des Herstellers Fujifilm; die HD4100 Serie des Herstellers HD MicroSystems; die Pimel BL-300 Serie und die BM-300 Serie des Herstellers Asahi Kasei. Unter den Polybenzoxazole (PBO) gibt es beispielsweise folgende kommerzielle Produkte: die HD-8820 Serie und die HD89xx Serie des Herstellers HD Microsystems.

Die Haftkraft reduzierende Zwischenschicht kann beispielsweise Organosilanverbindungen beinhalten (z.B. Hexamethyldisilazan (HMDS), Diphenylsilandiol). Diese können beispielsweise Si-O Verbindungen mit dem nativen Oxid des Trägers eingehen. Es bilden sich beispielsweise hydrophobe Oberflächen mit -CH3 oder -C6H5 Monolayer-Gruppen auf der Oberfläche 120 des Trägers 110.

Alternativ ist es auch möglich, dass das oben genannte Polymer der Schicht 130 nur relativ schwach auf dem jeweiligen Trägermaterial (beispielweise Silicium oder Glas) haftet, beispielsweise weil es keinen Build-In Adhesion-Promoter beinhaltet. In diesem Fall ist es möglich, einen entsprechenden "Adhesion Promoter" als Haftkraft verstärkende Zwischenschicht auf die Oberfläche des Trägers aufzubringen. Ein Beispiel für ein geeignetes Material für eine Haftkraft verstärkende Zwischenschicht sind beispielsweise Organosilan-Verbindungen. Diese sind insbesondere geeignet die Haftung von Polymeren, wie etwa Polyimiden, auf Trägermaterialien (wie etwa Silicium oder Glas) zu verstärken. Beispiele für derartige Polymere sind etwa Polyimide aus den Serien PI-2600, PI-2525, PI-2555 des Herstellers HD Microsystems. Als Material für die haftkraftverstärkende Zwischenschicht kommen beispielsweise Organosilan-Verbindungen in Frage, wie beispielsweise die Produkte VM-651 und VM-652 des Herstellers HD Microsystems.

Die haftkraftverstärkende Zwischenschicht kann beispielsweise Organosilanverbindungen beinhalten, welche beispielsweise Si-O Verbindungen mit dem (nativen) Oxid des Trägers eingehen, wie beispielsweise Amino-Propyltriethoxysilan. Die Aminogruppe kann beispielsweise als funktionelle Gruppe für Polyimid-Polymere in der Schicht 130 fungieren. Die Si-OCH₃ bildet beispielsweise Si-O Verbindungen mit nativen Oxid des Trägers 130 aus.

Im Unterschied zu einem gewöhnlichen Klebstoff bildet die haftkraftverstärkende Zwischenschicht vorzugsweise kovalente Bindungen mit dem jeweiligen Polymer der Schicht aus. Die haftkraftverstärkende Zwischenschicht liegt, wie bereits oben beschrieben, in der Form eines Monolayers (einer Monolage) vor und ist somit wesentlich dünner also herkömmliche Klebstoffschichten.

Vorzugsweise befindet sich zwischen der Schicht 130 und dem ersten Oberflächenbereich 121 des Trägers 110 keine weitere Schicht, zumindest keine weitere Schicht mit einer Schichtdicke größer als eine Monolage des diese Schicht bildenden Materials. Vorzugsweise ist keine Schicht eines Klebers zwischen der Schicht 130 und dem ersten Oberflächenbereich 121 des Trägers 110 angeordnet, die Dicker als eine entsprechende Monolage des Klebers ist.

Alternativ zu der oben beschriebenen Haftkraft reduzierenden Zwischenschicht ist es auch möglich, die Haftung des zweiten Bereichs 132 der Schicht 130 auf dem zweiten Oberflächenbereich 122 zu reduzieren, indem der zweite Oberflächenbereich 122 des Trägers und/oder der auf dem zweiten Oberflächenbereich 122 haftende zweite Bereich 132 der Schicht 130 durch den Träger 110 hindurch mit elektromagnetischer Strahlung bestrahlt wird. Bei der elektromagnetischen Strahlung kann es sich beispielsweise um Laserstrahlung handeln, wie beispielsweise um Laserstrahlung eines UV-Licht-Excimerlaser, beispielsweise mit λ= 248 nm oder 308 nm, oder um Laserstrahlung eines MidIR Lasers. Typischerweise wird durch Absorption der elektromagnetischen Strahlung und fotochemische Zersetzung das Haftungsinterinterface zwischen Polymer und Substrat vollständig oder zumindest teilweise zerstört. Beispielsweise können atomare und/oder molekulare Bindungen im Übergang zwischen Träger und der Schicht 130 zerstört werden, beispielsweise mittels Laserablation. Zudem können durch die Bestrahlung zwischen dem Träger und der Schicht gasförmige (Neben-)Produkte entstehen, die beispielsweise das Bondinterface zwischen dem Träger 110 und der Schicht 130 öffnen. Es kann optional eine Hilfsschicht zwischen der Schicht 130 und dem Träger 110 aufgebracht werden, welche beispielsweise Chromophore beinhalten kann und als Absorberschicht für die Strahlung wirkt. Hierfür kann beispielsweise das Produkt Brewer Bond 701 des Herstellers Brewer Science verwendet werden.

Wie in den nachfolgenden Figuren 2A, 2B, 3A und 3B gezeigt ist, wird auf der Oberfläche 120 des Trägers 110, genauer gesagt auf dem ersten Oberflächenbereich 121 und den beiden zweiten Oberflächenbereichen 122, die bereits erwähnte Schicht 130 hergestellt. Die Schicht 130 umfasst einen ersten Bereich 131, welche den ersten Oberflächenbereich 121 abdeckt. Die Schicht 130 umfasst im gezeigten Beispiel außerdem zwei zweite Bereiche 132, welche jeweils mit dem ersten Bereich 131 der Schicht 130 zusammenhängen. Jeder der beiden zweiten Bereiche 132 deckt jeweils genau einen der beiden zweiten Oberflächenbereiche 122 des Trägers 110 ab. Die Schicht 130 ist in diesem Beispiel mehrlagig und umfasst eine erste Teilschicht 133 sowie eine zweite Teilschicht 134, welche innerhalb des ersten Oberflächenbereichs 121 des Trägers 110 übereinander angeordnet sind.

In Figuren 2A und 2B ist der in Figuren 1A und 1B gezeigte Träger 110 in einer Ansicht von oben bzw. in einer Seitenansicht gezeigt, nachdem die erste Teilschicht 133 auf dem ersten Oberflächenbereich 121 des Trägers 110 sowie auf einen der beiden zweiten Oberflächenbereich 122 des Trägers 110 hergestellt worden ist. Der andere der beiden zweiten Oberflächenbereiche 122 wurde hierbei ausgespart.

In Figuren 3A und 3B ist der in Figuren 2A und 2B gezeigte Träger 110 in einer Ansicht von oben bzw. in einer Seitenansicht gezeigt, nachdem die zweite Teilschicht 134 auf dem ersten Oberflächenbereich 121 des Trägers 110 (dort auf der ersten Teilschicht134) sowie auf denjenigen der beiden zweiten Oberflächenbereiche 122 des Trägers 110 hergestellt worden ist, auf dem die erste Teilschicht 133 nicht hergestellt worden ist. Derjenige der beiden zweiten Oberflächenbereiche 122, auf denen die erste Teilschicht 133 aufgetragen worden ist, wurde somit nun ausgespart.

Die Schicht 130 wird also im ersten Oberflächenbereich beispielsweise direkt auf dem Material des Trägers 110 hergestellt wird und in den zweiten Oberflächenbereichen 122 auf das Material der haftkraftreduzierenden Zwischenschicht. Alternativ ist es möglich das die Schicht 130 im ersten Oberflächenbereich beispielsweise auf das Material einer haftkraftverstärkenden Zwischenschicht hergestellt und in den beiden zweiten Oberflächenbereichen 122 direkt auf dem Material des Trägers 110 hergestellt wird.

Die Schicht 130 kann ganz oder zumindest bereichsweise eine aus einem Polymer, beispielsweise aus Polyimid oder Polybenzoxazol, aus einem Metall, aus Glas oder aus Silizium oder aus einer Kombination von zwei oder mehr dieser Materialien gebildet sein. Um die genannte Flexibilität bzw. Biegsamkeit der Schicht zu erzielen, kann vorgesehen sein, dass die Schicht eine hinreichend kleine Gesamtdicke aufweist. Auf diese Weise können auch relativ starre oder spröde Materialien zur Bildung der flexiblen Schicht verwendet werden.

Die Schicht 130 kann zusätzlich zu den gezeigten Teilschichten 133,134 noch weitere Schichten umfassen. Die Teilschichten 133, 134 bzw. die weiteren Teilschichten können sich durch ihre Materialien und Funktionen voneinander unterscheiden. Bei den Teilschichten 133, 134 kann es sich beispielsweise um elektrische Isolationsschichten handeln, die aus einem elektrisch isolierenden Material gebildet ist, wie beispielsweise die oben genannten Polymeren, oder um weitere Haftkraft reduzierende Zwischenschichten, um beispielsweise ein teilweise ablösen der Teilschichten 133,134 voneinander zu ermöglichen.

Auf bzw. zwischen den Isolationsschichten können beispielsweise Leitungsschichten gebildet sein, welche beispielsweise elektrisch leitendende Materialien beinhalten. Als elektrische leitende Materialien kommen beispielsweise Metalle, wie beispielsweise Kupfer (Cu), Aluminium (Al), Titan (Ti) und Gold (Au). Auch diese Leitungsschichten können mit den beschriebenen Dünnschichttechniken und lithographischen Verfahren hergestellt und strukturiert werden, wie weiter unten näher beschrieben wird.

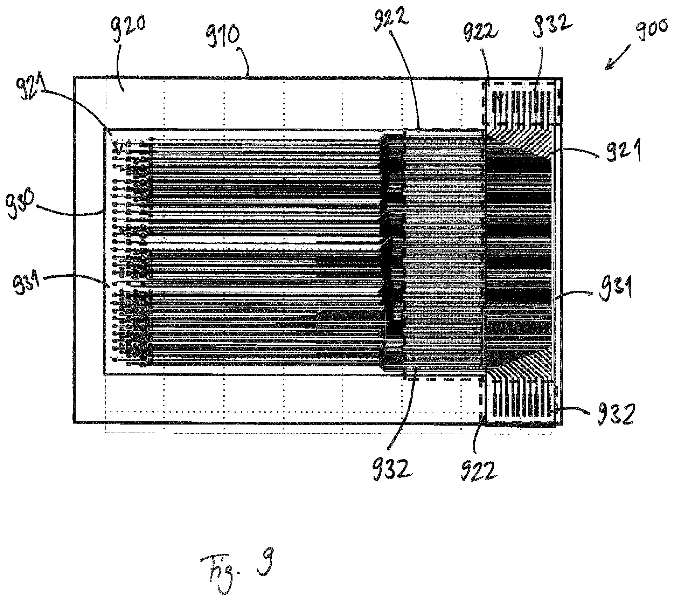

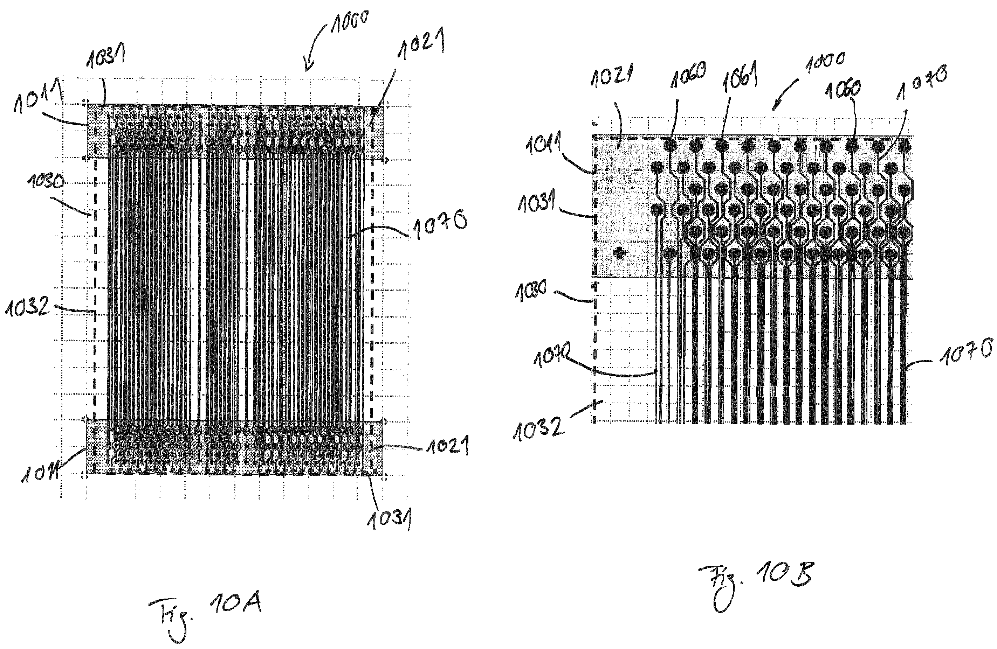

Beispielsweise umfasst die Leitungsschicht mindestens eine Leitung (hier nicht gezeigt), beispielsweise eine elektrische Leiterbahn, die sich ausgehend von dem ersten Bereich 131 der Schicht 130 bis in einen der beiden zweiten Bereiche 132 der Schicht 130 erstreckt. Beispiele für Leitungsschichten mit Leiterbahnen sind in Figuren 9, 10A und 10B gezeigt.

Die Isolationsschichten haben beispielsweise jeweils eine Schichtdicke in einem Bereich zwischen 1 µm und 300 µm, beispielsweise 10 µm. Die Leiterschichten haben beispielsweise jeweils eine Schichtdicke in einem Bereich von 0,25 µm bis 100µm, beispielsweise 5 µm. Die Leibahnbreiten und Abstände zwischen den Leiterbahnen können beispielsweise 0,5 µm oder mehr betragen, beispielsweise 1 bis 30 µm oder bis zu 250 µm.

Es kommen alternativ oder zusätzlich noch weitere Teilschichten der Schicht 130 in Frage, wie beispielsweise die weiter oben erwähnten elektrischen, optischen und/oder mikrofluidischen Isolationsschichten und elektrischen, optischen und/oder mikrofluidischen Leitungsschichten sowie gegebenenfalls auch Haftkraft reduzierende Zwischenschichten, um das Ablösen darüber angeordneter Bereiche von Teilschichten der Schicht zu ermöglichen oder zu erleichtern.

Zur Herstellung der Schicht 130, also insbesondere der Teilschichten 131, 132, sowie gegebenenfalls weiterer Teilschichten, wie beispielsweise Isolationsschichten, Leitungsschichten und Haftkraft reduzierender Schichten, können beispielsweise bekannte Dünnfilmtechniken angewendet werden, wie insbesondere PVD, CVD, Fotolithografie und Laserablation. Zum Beispiel können die Leitungsschichten durch Abscheiden einer Leitungsschicht mittels PVD oder CVD und anschließender lithografischer Maskierung und galvanischer Abscheidung oder Direktätzung (subtraktive Strukturierung) hergestellt werden. Möglich sind auch chemische Direktmetallisierungsverfahren zur Aufbringung der Leitungsschicht. Bevorzugt sind PVD und anschließende galvanische Verstärkung. Isolationsschichten, wie beispielsweise Polymerschichten, können beispielsweise mittels Spin-Coating aufgetragen and anschließend strukturiert werden, bevorzugt fotolithografisch oder durch Laserablation. Beispielsweise kann eine thermische Behandlung oder Polymerisierung der Polymerschicht durchgeführt werden.

Der oben beschriebene Aufbau der Schicht 130 ist lediglich ein mögliches Ausführungsbeispiel unter vielen. In alternativen Ausführungsbeispielen kann die Schicht 130 auch eine Metallfolie sein oder eine funktionale Polymerfolie, z.B. für optische Applikationen oder für Filter.

Wie in der Figur 4A und besonders deutlich in der Figur 4B gezeigt ist, sind die beiden zweiten Bereiche 132 der Schicht 130 von den beiden zweiten Oberflächenbereichen 122 des Trägers 110 abgelöst worden. Diejenigen Bereiche des Trägers 110, welche zuvor die beiden zweiten Oberflächenbereiche 122 bildeten (sowie in diesem Beispiel auch alle weiteren Bereiche des Trägers 110, welche nicht den ersten Oberflächenbereich 121 oder den zweiten Oberflächenbereich 122 Trägers 110 bildeten), sind entfernt worden. Somit ragen die beiden abgelösten zweiten Bereiche 132 der Schicht 130 seitlich über den jetzigen Rand des Trägers 110 hinaus. Sie sind beispielsweise nach unten (d. h., in Richtung des Trägers 110) gebogen worden könnten aber genauso gut nach oben vom Träger weg gebogen sein. Jeder der beiden zweiten Bereiche 132 weist somit einen gekrümmten Bereich 135 und einen ebenen Bereich 136 auf. Der Biegeradius des gekrümmten Bereichs 135 entspricht beispielsweise dem Fünffachen der Gesamtdicke des jeweiligen zweiten Bereichs 132 der Schicht 130, könnte aber beispielsweise auch wesentlich geringer sein, und je nach Biegsamkeit beispielsweise der Gesamtdicke des zweiten Bereichs 132 der Schicht 130 oder weniger entsprechen.

Insbesondere sind die zweiten Bereiche 132 somit aus der durch den ersten Oberflächenbereich 121 des Trägers 110 definierten Ebene herausgebogen, so dass die jeweiligen ebenen Bereiche 136 (bzw. die hierdurch definierten Ebenen) jeweils den oben genannten Winkel mit der durch den ersten Oberflächenbereich 121 des Trägers gebildeten Ebene einschließen. Der Winkel kann aufgrund der Biegsamkeit der Schicht in den abgelösten zweiten Bereichen 132 praktisch beliebig gewählt werden. Beispielsweise liegt der Winkel in einem Bereich zwischen 45° und 135°, beispielsweise bei etwa 90°. Prinzipiell sind Biegungen um beliebige Achsen mögliche, also insbesondere auch Verdrehungen (Torsionen) der abgelösten zweiten Bereiche 131.

Beispielsweise können die beiden zweiten Bereiche 132 der Schicht 130 vom Träger 110 abgelöst worden sein, indem beispielsweise diejenigen Bereiche des Trägers 110, welche die zweiten Oberflächenbereich 122 Trägers 110 bilden (sowie in diesem Beispiel auch alle weiteren Bereiche des Trägers 110, welche nicht den ersten Oberflächenbereich 121 oder den zweiten Oberflächenbereich 122 Trägers 110 bilden), durch Ätzen entfernt worden sind. Hierzu kann beispielsweise auf der (der Schicht 130 abgewandten) Rückseite des Trägers 110 eine entsprechend strukturierte Ätzmaske hergestellt worden sein, beispielsweise mittels bekannter lithographischer Verfahren. Das Ätzen kann beispielsweise mittels bekannter DRIE-Verfahren oder nasschemisch erfolgen. Als für Ätzverfahren besonders geeignetes Material für den Träger 110 kommt beispielsweise Silicium in Frage. Beispielsweise kann der Träger 110 für die Durchführung des Ätzverfahrens auf einem temporären Träger befestigt werden, zum Beispiel auf einem Dicing Tape, einem Filmframe oder einem alternativen Substrat.

Es ist aber auch möglich, dass die beiden zweiten Bereiche 132 der Schicht 130 von den beiden zweiten Oberflächenbereiche 121 mechanisch getrennt worden sind, beispielsweise durch Abziehen, insbesondere in dem Fall, dass auf den beiden zweiten Oberflächenbereiche 121 jeweils eine Haftkraft reduzierenden Zwischenschicht angeordnet ist, wie oben beschrieben.

Schließlich ist es auch möglich, dass die beiden zweiten Bereiche 132 der Schicht 130 von den beiden zweiten Oberflächenbereichen 121 des Trägers 110 mittels elektromagnetischer Bestrahlung abgelöst werden, beispielsweise mittels UV-Licht Excimerlaser mit einer Wellenlänge von beispielsweise 248 nm oder 308 nm oder mit Laserstrahlung eines MidIR Laser, wie oben beschrieben. Vorzugsweise ist das Material des Trägers 110 für die elektromagnetische Strahlung transparent, damit die Bestrahlung durch das Material des Trägers hindurch erfolgen kann, beispielsweise ausgehend von einer der Schicht 130 abgewandten Unterseite des Trägers. Zum Beispiel kann der Träger 110 aus einem für die Strahlung transparenten Glas gebildet sein.

Beispielsweise können auch nach dem mechanischen und/oder mittels Laserbestrahlung erfolgten Ablösen der beiden zweiten Bereiche 132 der Schicht 130 diejenigen Bereiche des Trägers 110, welche nicht den ersten Oberflächenbereich 121 bilden, entfernt werden. Dies kann beispielsweise erfolgen, indem diese Bereiche des Trägers 110 vor oder nach dem Schritt des Ablösens der ersten Bereiche 131 der Schicht 130 vom Rest des Trägers 110 abgetrennt werden, beispielsweise mittels einer Säge oder eines Lasers. Beispielsweise kann der Träger 110 entlang von Schnittebenen durchtrennt werden, welche beispielsweise zwischen dem ersten Oberflächenbereich 121 und jeweils einem den beiden zweiten Oberflächenbereichen 122 verlaufen. Beim Durchtrennen des Trägers 110 wird die Schicht 130 jedoch nicht durchtrennt.

Zudem ist auf jedem der beiden zweiten Bereich 132 der Schicht 130 jeweils mindestens ein Kontaktelement (hier nicht dargestellt), ein mechanisches Verbindungselement (hier nicht dargestellt) und/oder ein Bauteil 150 angeordnet. Das Kontaktelement und/oder Bauteil ist beispielsweise mit mindestens einem elektrischen Leiter der Leitungsschicht(en) der Schicht 130 verbunden. Weitere Bauteile und Kontaktelemente (nicht dargestellt) können beispielsweise auf der Schicht 130 angeordnet sein oder in der Schicht 130 integriert sein, beispielsweise in den abgelösten zweiten Bereichen 132 oder in dem ersten Bereich der Schicht 130.

Beispiele für die genannten Bauteile 150 sind unter anderem CMOS Chips, Speicher, CPUs, MEMS, MOEMS, passive Elemente wie beispielsweise Widerstände, Antennen, Spulen, Kondensatoren sowie außerdem Sensoren und Aktuatoren. Weitere Beispiele für die Bauteile sind weiter oben genannt worden. Die Kontaktelemente und mechanischen Verbindungselemente können beispielsweise Kontaktleisten, Steckverbindungselemente, Steckerleisten, Außenkontakte für Steckverbindungen, Lotkontakte, Drahtbond-Pads, Kontaktpads, beispielsweise für Thermokompressions-Verbindungen, Micro-Kontaktelemente oder Micro-Lotbumps oder Bonddrähte sein.

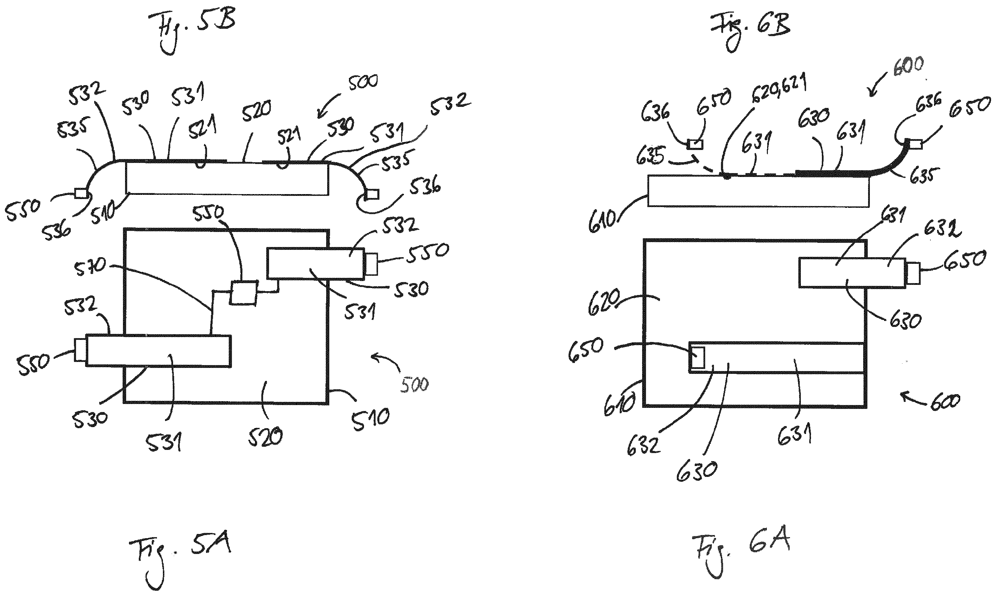

In Figuren 5A und 5B ist ein weiteres Ausführungsbeispiel einer Trägeranordnung 500 hier vorgeschlagene Art gezeigt, welche beispielsweise mit dem gleichen Herstellungsverfahren hergestellt worden sein kann, wie die in Figur 4A und 4B gezeigte Trägeranordnung 100 und sich von dieser beispielsweise nur durch ihre geometrische Ausgestaltung unterscheidet. (Die Bezugszeichen entsprechender Merkmale sind daher im Vergleich zu dem in Figuren 4A und 4B gezeigten Ausführungsbeispiel um 400 erhöht.) Im Folgenden werden daher vor allem die Unterschiede zu der in Figuren 4A und 4B gezeigten Trägeranordnung beschrieben.

Die Trägeranordnung 500 weist somit einen Träger 510 auf, der in seinem Aufbau beispielsweise mit dem in Figuren 4A und 4B gezeigten Träger 110 übereinstimmen kann, auf dessen Oberfläche 520 aber nicht wie in Figuren 4A und 4B gezeigt nur eine zusammenhängende Schicht 130 angeordnet ist, sondern beispielsweise zwei räumlich voneinander getrennte Schichten 530 angeordnet sind. Die Schichten 530 können beispielsweise in ihrer Herstellung und ihrem Aufbau der Schicht 130 der in Figuren 4A und 4B gezeigten Trägeranordnung 100 entsprechen. Somit weisen die Schichten 530 jeweils einen ersten Bereich 531 auf, welche jeweils auf einem von zwei voneinander räumlich getrennten ersten Oberflächenbereichen 521 des Trägers 510 angeordnet sind. Jede der Schichten 530 weist zudem einen flexiblen zweiten Bereich 532 auf, der mit dem ersten Bereich 531 jeweiligen Schicht 530 zusammenhängt und nicht auf der Oberfläche 520 des Trägers 510 angeordnet ist, sondern beispielsweise seitlich über einen Rand des Trägers 510 hinaus ragt und nach unten in Richtung des Trägers 510 gebogen ist.

In Figur 5A ist außerdem zusätzlich zu dem Bauteil 550 auf den beiden zweiten Bereichen 532 der Schicht 530 ein mögliches weiteres Bauteil 550 der Trägeranordnung 500 gezeigt, welches auf der Oberfläche 520 des Trägers 510 angeordnet ist, und über Leiterbahnen 570 mit in den Schichten 530 integrierten Leiterbahnen (nicht gezeigt) sowie mit den auf den zweiten Bereichen 531 der Schichten 530 angeordneten Bauteilen 550 verbunden ist. Für die in Figuren 5A und 5B gezeigten Bauteile 550 kommen beispielsweise die gleichen Beispiele infrage wie oben für die in Figuren 4A und 4B gezeigten Bauteile 150 angegeben.

Das in Figuren 6A und 6B gezeigte Ausführungsbeispiel einer Trägeranordnung 600 unterscheidet sich von der in Figuren 5A und 5B gezeigten Trägeranordnung 500 im Wesentlichen nur durch ihre geometrische Ausgestaltung. (Die Bezugszeichen entsprechender Merkmale sind daher im Vergleich zu dem in Figuren 5A und 5B gezeigten Ausführungsbeispiel um 100 erhöht.) Wie in dem in Figuren 5A und 5B gezeigten Ausführungsbeispiel 500, weist die Trägeranordnung 600 zwei auf einem Träger 610 angeordnete Schichten 630 auf mit jeweils einem ersten Bereich 631, welcher jeweils auf einem von zwei voneinander räumlich getrennten ersten Oberflächenbereichen 621 des Trägers 610 angeordnet ist. Jede der Schichten 630 weist zudem einen flexiblen zweiten Bereich 632 auf, der mit dem ersten Bereich 631 der jeweiligen Schicht 630 zusammenhängt und nicht auf der Oberfläche 620 des Trägers 610 angeordnet ist. In einem Fall ragt einer der beiden zweiten Bereiche 632 seitlich über einen Rand des Trägers 610 hinaus und ist nach oben von dem Träger 610 weggebogen. Der andere der beiden zweiten Bereiche 632 ragt seitlich nicht über einen Rand des Trägers 610 hinaus, sondern ist über der Oberfläche 620 des Trägers 610 angeordnet und nach oben von der Oberfläche 620 des Trägers 610 weg gebogen.

Somit bilden die beiden flexiblen abgelösten Bereiche 532 der Schicht 530 in dem in Figuren 5A und 5B gezeigten Beispiel sogenannte Fan-Out-Konstruktionen, da sie über den Rand des Trägers 510 seitlich hinausragen und somit nicht mehr über dessen Grundfläche angeordnet sind. Dahingegen bildet in dem in Figuren 6A und 6B gezeigten Beispiel nur einer der beiden abgelösten Bereiche 632 eine solche Fan-out-Konstruktion. Der andere abgelöste Bereich 632, der nicht seitlich über den Rand des Trägers 610 hinausragt sondern oberhalb der Oberfläche 610 angeordnet ist, bildet eine so genannte Fan-In-Konstruktion.

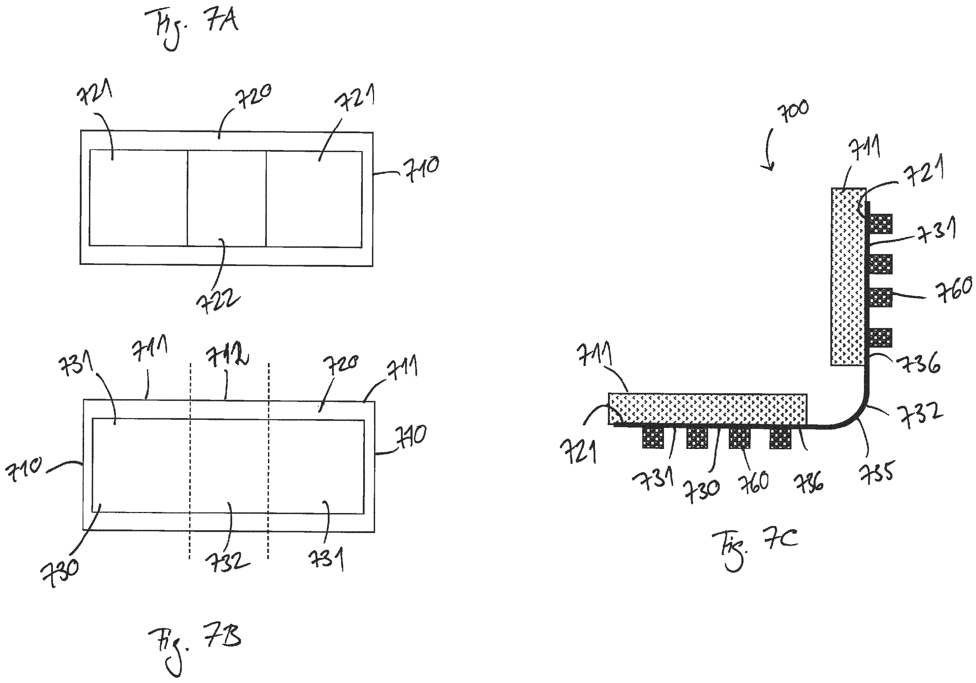

Anhand der Figuren 7A, 7B und 7C wird die Herstellung und die Ausgestaltung eines weiteren Ausführungsbeispiels einer Trägeranordnung 700 hier vorgeschlagene Art beschrieben. Die Trägeranordnung 700 unterscheidet sich beispielsweise von der in Figuren 4A und 4B gezeigten Trägeranordnung 100 im Wesentlichen durch ihre geometrische Ausgestaltung. Entsprechende Merkmale der Trägeranordnung 700 sind daher mit Bezugszeichen versehen, welche im Vergleich zur in Figuren 4A und 4B gezeigten Trägeranordnung 100 um 600 erhöht sind.

In Figur 7A ist ein Träger 710 der Trägeranordnung 700 gezeigt, der beispielsweise dem in Figuren 4A und 4B gezeigten Träger 110 entsprechen kann. Eine ebene Oberfläche 720 des Trägers 710 weist zwei voneinander räumlich getrennte erste Oberflächenbereiche 721 sowie einen dazwischen liegenden und an die beiden ersten Oberflächenbereich 721 jeweils angrenzenden zweiten Oberflächenbereich 722 auf. Wie in Figur 7B gezeigt ist, ist auf diese Oberflächenbereiche 721,722 eine zusammenhängende Schicht 730 hergestellt worden. Diese Schicht 730 kann in ihrer Herstellung, Zusammensetzung und Struktur beispielweise der oben beschriebenen Schicht 130 entsprechen. Die Schicht 730 umfasst zwei erste Bereiche 731, die jeweils einen der beiden ersten Oberflächenbereiche 721 abdecken, sowie einen zweiten Bereich 732, der mit den beiden ersten Bereichen 731 jeweils zusammenhängt und den zweiten Oberflächenbereich 722 abdeckt.

Zudem sind in Figur 7B zwei Schnittebenen als gestrichelte Linien dargestellt. Der Träger 710 wird beispielsweise mittels einer Säge oder eines Lasers entlang dieser Schnittebenen durchtrennt, ohne hierbei aber die Schicht 730 zu durchtrennen. Hierdurch wird der Träger 710 in zwei seitliche erste Trägersegmente 711, welche jeweils einen der beiden ersten Oberflächenbereiche 721 bilden, und in ein mittleres zweites Trägersegment 712, welches den zweiten Oberflächenbereich 722 bildet, zerteilt.

In einem nachfolgenden Schritt wird der zweite Bereich 732 der Schicht 730 von dem zweiten Oberflächenbereich 722 abgelöst und somit von dem mittleren zweiten Trägersegment 712 getrennt. Das Ablösen kann beispielsweise mechanisch durch Abziehen des zweiten Bereichs 732 von dem zweiten Oberflächenbereich 722 erfolgen und/oder mittels Laserbestrahlung, wie oben beschrieben. Hierfür wäre es beispielsweise möglich, wie ebenfalls oben beschrieben, auf den beiden ersten Oberflächenbereichen 721 eine Haftkraft verstärkende Zwischenschicht aufzutragen oder auf dem zweiten Oberflächenbereich 722 eine Haftkraft reduzierende Zwischenschicht aufzutragen, um das mechanische Ablösen zu erleichtern, und/oder auf dem zweiten Oberflächenbereich 722 eine Absorberschicht aufzubringen, welche die Absorption der Laserstrahlung verbessert.

Alternativ wäre es außerdem möglich, das Ablösen chemisch durchzuführen, beispielsweise indem das mittlere zweite Trägersegment 712 durch Ätzen entfernt wird, beispielsweise unter Verwendung einer Ätzmaske, wie ebenfalls oben beschrieben. In diesem Fall wäre es prinzipiell auch möglich, auf das Durchtrennen des Trägers mittels einer Säge oder Lasers zu verzichten.

Wie in Figur 7C gezeigt ist, wird der abgelöste zweite Bereich 732 der Schicht 730 um etwa 90° gebogen, sodass die beiden verbliebenen ersten Trägersegmente 711 etwa senkrecht zueinander stehen. Genauso gut wären natürlich auch andere Winkel sowie auch ein Falten des abgelösten zweiten Bereichs 732 möglich, sodass die beiden Trägersegmente beispielsweise parallel zueinander ausgerichtet sind, wobei jedoch die beiden ersten Oberflächenbereiche 721 beispielsweise einander zugewandt sind oder voneinander abgewandt sind. Zudem ist auch ein Verdrehen (Torsion) des abgelösten zweiten Bereichs 732 realisierbar.

Wie in Figur 7C außerdem gezeigt ist, sind auf den beiden ersten Bereichen 731 der Schicht 730 Kontaktelemente 760 angeordnet, welche eine elektrische Kontaktierung von in der Schicht 730 integrierten elektrischen Leitern ermöglichen.

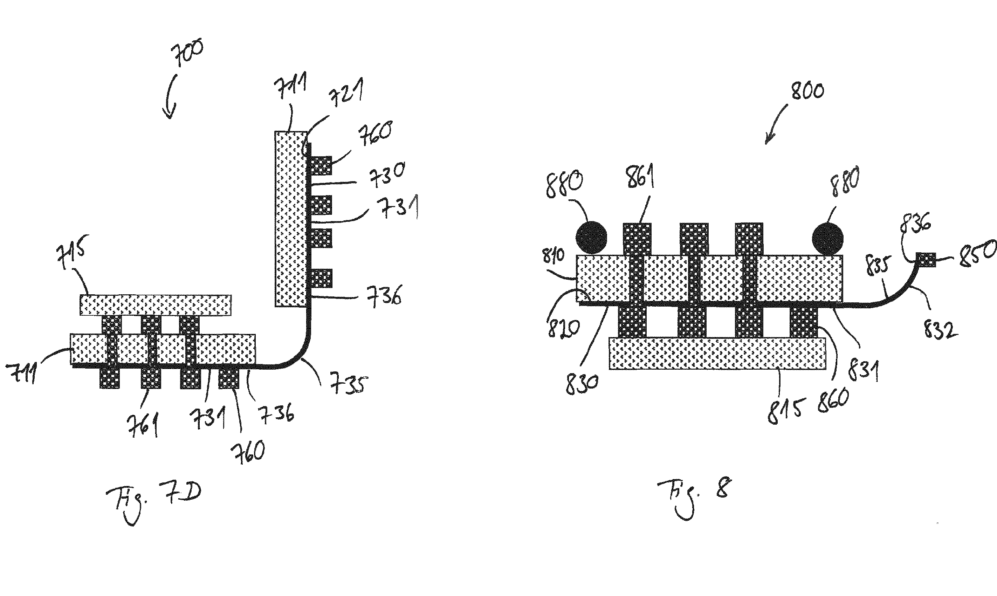

In Figur 7D ist eine Variante der in Figur 7C gezeigten Trägeranordnung 700 dargestellt, bei der eines der beiden Trägersegmente 711 mit Durchkontaktierung 761 ausgestattet ist, welche eine beidseitige elektrische Kontaktierung von in der Schicht 730 integrierten elektrischen Leitern ermöglichen, also Insbesondere von der Oberseite des Trägersegments 711 aus, auf der die Schicht 730 angeordnet ist, sowie von einer gegenüberliegenden Rückseite des Trägersegments 711 aus. In dem gezeigten Beispiel ist auf der Rückseite des Trägersegments 711 ein weiterer Träger (Substrat) 715 der Trägeranordnung 700 befestigt und über die durch die Durchkontaktierungen 761 mit den in der Schicht 130 integrierten Leitungen elektrisch verbunden.

In den in Figuren 7C und 7D gezeigten Ausführungsbeispielen sind die beiden Trägersegmente 711 nur durch den flexiblen zweiten Bereich 732 der Schicht 730 verbunden. Dadurch ist die mechanische wie auch thermische Kopplung zwischen den beiden Trägersegmenten 711 reduziert, wodurch insbesondere thermo-mechanische Spannungen reduziert werden können.

In Figur 8 ist ein weiteres Ausführungsbeispiel einer Trägeranordnung 800 hier vorgeschlagene Art gezeigt, welches mit dem oben beschriebenen Verfahren hergestellt werden kann. Die Trägeranordnung 800 umfasst somit einen Träger 810, der beispielsweise aus Glas oder Silizium gefertigt sein kann, und auf dessen Oberfläche 820 ein erster Bereich 831 einer Schicht 830 angeordnet ist. Die Schicht 830 weist außerdem einen zweiten Bereich 832 auf, der mit dem ersten Bereich 831 zusammenhängt und nicht auf der Oberfläche 820 angeordnet ist, sondern seitlich über einen Rand des Trägers 810 hinausragt und in Richtung des Trägers gebogen ist. Beispielsweise kann die Schicht 830 mittels der im Zusammenhang mit dem in Figur 4A und 4B gezeigten Ausführungsbeispiel 100 beschriebenen Herstellungsverfahren erzeugt worden sein und entsprechende Merkmale aufweisen. Ähnlich wie im in Figur 7D gezeigten Ausführungsbeispiel 700 weist auch der Träger 800 Kontaktelemente 860 sowie Durchontaktierungen 861 auf, über die jeweils eine elektrische Verbindung mit einer oder mehreren in der Schicht 830 integrierten elektrischen Leitern hergestellt werden kann. Über die Durchkontaktierungen 761 ist auf der Oberseite des Trägers 810 ein weiterer Träger 815 (Substrat) der Trägeranordnung 800 mit dem Träger 810 mechanisch verbunden und zudem auch mit den genannten Leitern der Schicht 830 elektrisch verbunden. Auf der Rückseite des Trägers 810, welche der genannten Oberseite entgegengesetzt ist, sind neben den Durchkontaktierungen 861 weitere Verbindungselemente 880 angeordnet, welche eine mechanische und/oder elektrische Verbindung eines noch weiteren Trägers (hier nicht gezeigt) mit dem Träger 810 ermöglichen, vorzugsweise mittels einer Lotverbindung. Die mechanischen Verbindungselemente 880 sind beispielsweise durch sogenannte Micro-Kontaktelemente oder sogenannten Micro-Lotbumps, Bonddrähten oder Steckverbindungselemente gebildet.

Die in Figur 8 gezeigte Trägeranordnung 800 kann beispielsweise als sogenannter Interposer verwendet werden, in dem es beispielsweise mit den mechanischen Verbindungselementen 880 und Durchkontaktierungen 861 auf einem weiteren Träger (hier nicht dargestellt) befestigt wird. Das Bauteil 850 auf dem abgelösten zweiten Bereich 832 der Schicht 830 kann beispielsweise eine Steckerleiste mit elektrischen und/oder optischen Kontakten sein oder als eine beliebige andere Schnittstelle ausgestaltet sein. Der abgelöste zweite Bereich 832 bildet eine sogenannte Fan-Out-Struktur.

In Figur 9 ist ein Zwischenstadium in der Herstellung eines weiteren Ausführungsbeispiels einer noch nicht fertiggestellten Trägeranordnung 900 hier vorgeschlagener Art gezeigt. Gezeigt ist einer Träger 910, der beispielsweise aus Glas oder Silizium gefertigt sein kann und dessen Oberfläche 920 beispielsweise zwei erste Oberflächenbereiche 921 und drei zweite Oberflächenbereiche 922 (jeweils mit gestrichelten Linien umrandet) aufweist. Auf den drei zweiten Oberflächenbereichen 922 ist beispielsweise jeweils eine Haftkraft reduzierende Zwischenschicht hergestellt worden, beispielsweise wie bereits oben im Zusammenhang mit dem in Figur 4A und 4B gezeigten Ausführungsbeispiel beschrieben. Auf der Oberfläche 920 ist anschließend eine zusammenhängende Schicht 930 hergestellt worden. Die Schicht 930 weist zwei erste Bereiche 931 auf, die jeweils einen der beiden ersten Oberflächenbereiche 921 abdecken, sowie drei mit den beiden ersten Bereichen 931 zusammenhängende zweite Bereiche 932, die jeweils eine der drei zweiten Oberflächenbereiche 922 abdecken. Beispielsweise kann die Schicht 930 mittels der im Zusammenhang mit dem in Figur 4A und 4B gezeigten Ausführungsbeispiel 100 beschriebenen Herstellungsverfahren erzeugt worden sein und entsprechende Merkmale aufweisen. Gezeigt sind hier insbesondere elektrische Leitungen 970, die in der Schicht 930 beispielsweise eingebettet sind und welche die ersten und zweiten Bereich 931, 932 der Schicht durchlaufen und miteinander verbinden. Ähnlich wie auch in den in Figur 7D und 8 gezeigten Ausführungsbeispielen 700, 800 weist auch der Träger 910 Kontaktelemente 960 sowie Durchkontaktierungen 961 auf, über die jeweils eine elektrische Verbindung mit einer oder mehreren der in der Schicht 830 integrierten elektrischen Leitungen 970 hergestellt werden kann.

In nachfolgenden Verfahrensschritten (hier nicht gezeigt) können die drei zweiten Bereiche 932 der Schicht 930 von den zweiten Oberflächenbereichen 922 abgelöst werden, beispielsweise unter Anwendung eines der oben beschriebenen Verfahren, beispielsweise durch mechanisches Ablösen. Zuvor oder nachfolgend kann der Träger 910 in erste und zweite Trägersegmente zerteilt werden, beispielsweise indem der Träger 910 entlang von Schnittebenen durchgesägt wird. Beispielsweise können diese Schnittebenen zwischen den ersten und zweiten Oberflächenbereichen 921,922 verlaufen. Hierbei entstehen vorzugsweise erste und zweite Trägersegmente, wobei jedes der ersten Trägersegmente jeweils einen der ersten Oberflächenbereiche 921 bildet und jedes der zweiten Trägersegmente jeweils einen der zweiten Oberflächenbereiche 921 bilden. Typischerweise werden die zweiten Trägersegmente von der Trägeranordnung 930 entfernt, bilden somit also keine Teile der fertiggestellten Trägeranordnung 900. Nach dem Ablösen sind die Bereich 932 biegsam und können beispielsweise gedreht oder gebogen werden, um eine gewünschte relative Ausrichtung der Trägersegmente zueinander zu ermöglichen.

In Figuren 10 A und 10B ist ein weiteres Ausführungsbeispiel einer Trägeranordnung 1000 hier vorgeschlagene Art schematisch dargestellt, wobei Figur 10B einen vergrößerten Teilausschnitt der Figur 10A zeigt. Die Trägeranordnung 1000 entspricht in ihrer Herstellung und ihrer Struktur beispielsweise dem in Figuren 7A, 7B und 7C gezeigten Ausführungsbeispiel 700 und umfasst somit ebenfalls zwei starre erste Trägersegmente 1011 sowie eine Schicht 1030, deren Rand in Figuren 10A und 10B durch eine gestrichelte Linie dargestellt ist. Die Schicht 1030 umfasst zwei erste Bereiche 1031, welche die durch die ersten Trägersegmente 1011 gebildeten erste Oberflächenbereiche 1021 abdecken, sowie einen zweiten Bereich 1032, welcher mit den beiden ersten Bereichen 1031 zusammenhängt, aber nicht auf den ersten Trägersegmenten 1011 angeordnet ist, sondern zwischen diesen verläuft und diese somit miteinander verbindet. Aufgrund der Flexibilität der Schicht 1030 in dem von dem ursprünglichen Träger 1010 abgelösten zweiten Bereich 1032, können die beiden ersten Trägersegmente 1011 relativ zueinander bewegt werden du beispielsweise Ausgleichsbewegungen relativ zueinander ausführen.

Die Schicht 1030 ist mehrlagig ausgestaltet und umfasst insbesondere elektrische Isolationsschichten sowie elektrische Leitungsschichten, bildet somit beispielsweise eine Verdrahtungsschicht. Die Leitungsschichten umfassen elektrische Leitungen 1070, welche jeweils durch die beiden ersten Bereiche 1031 und den zweiten Bereich 1032 der Schicht 1030 hindurch verlaufen, und somit eine elektrische Signalübertragung zwischen den beiden ersten Trägersegmente 1011 erlauben. Auf den beiden ersten Trägersegmenten 1011 sind zudem elektrische Kontaktelemente 1060 sowie Durchkontaktierungen 1061 angeordnet, welche jeweils eine elektrische Kontaktierung der Leitungen 1070 ermöglichen. Die Kontaktelemente 1060 und/oder die Durchkontaktierungen 1061 können beispielsweise bereits vor der Herstellung der Schicht 1030 auf den ersten Oberflächenbereichen 1021 hergestellt worden sein oder auch erst danach.

Bei den hier gezeigten Ausführungsbeispielen handelt es beispielsweise auch um Mikrosysteme oder Teile von Mikrosysteme, beispielsweise für mikroelektronische, mikromechanische, mikrofluidische und/oder elektro-optische Anwendungen. Wie bereits erwähnt, können die gezeigten Trägeranordnungen mit weiteren Bauteilen (siehe die oben genannten Beispiele von Bauteilen) verbunden werden, insbesondere über die gezeigten Kontaktelemente und Durchkontaktierungen. Zudem können weitere Bauteile und weitere Träger auf den gezeigten Trägern, Trägersegmenten, und weiteren Trägern angeordnet werden, sowie auf oder innerhalb der gezeigten Schichten, um die Funktionalität des jeweiligen Mikrosystems zu erweitern und/oder um weitere Kontaktebenen und Schnittstellen zu schaffen. Vorteilhafterweise können durch die flexiblen Bereiche der jeweiligen Schichten Substrateinflüsse sowie auch thermo-mechanische Spannungen reduziert werden.

Vorteilhafterweise können für viele Ausführungsbeispiele der Erfindung bekannte Verfahren der Mikroelektronik bzw. Mikrosystemtechnik verwendet werden, wie beispielsweise Dünnschichtverfahren, lithografische Verfahren, Ätzverfahren, Laserablationsverfahren und andere. Diese Verfahren können vorteilhafterweise in einem einzigen Prozessverfahren kombiniert werden, wodurch der Aufwand des vorgeschlagenen Herstellungsverfahrens im Vergleich zu herkömmlichen Herstellungsverfahren deutlich reduziert werden kann.

### Bezugszeichenliste:

| | |
|---|---|
| 100; 500; 600; 700; 800; 900; 1000 | Trägeranordnung |
| 110; 510; 610; 710; 810; 910; 1010 | Träger; Substrat |
| 711; 1011 | erstes Trägersegment |
| 712; 1012 | zweites Trägersegment |
| 715; 815 | weiterer Träger; Substrat |
| | |
| 120; 520; 620; 720; 820; 920; 1020 | Oberfläche |
| 121; 521; 621; 721; 821; 921; 1021 | erster Oberflächenbereich |
| 122; 722; 922 | zweiter Oberflächenbereich |
| 130; 530; 630; 730; 830; 930; 1030 | Schicht |
| 131; 531; 631; 731; 831; 931; 1031 | erster Bereich |
| 132; 532; 632; 732; 832; 932; 1032 | zweiter Bereich |
| 133, 134 | Teilschicht |
| 135; 535; 635; 735; 835 | gekrümmter Bereich |
| 136; 536; 636; 736; 836 | ebener Bereich |
| 150; 550; 650; 850 | Bauteil |
| 760; 860; 960; 1060 | Kontaktelement |
| 761; 861; 961; 1061 | Durchkontaktierung |
| 570; 970; 1070 | Leitung |
| 880 | Verbindungselement |

## Patentansprüche

1. Verfahren zum Herstellen einer Trägeranordnung (100; 500; 600; 700; 800; 900; 1000), umfassend die folgenden Schritte:
- Herstellen einer Schicht (130; 530; 630; 730; 830; 930; 1030) auf einer Oberfläche (120; 520; 620; 720; 820; 920; 1020) eines Trägers (110; 510; 610; 710; 810; 910; 1010), wobei die Schicht einen ersten Bereich (131; 531; 631; 731; 831; 931; 1031) und einen mit dem ersten Bereich zusammenhängenden zweiten Bereich (132; 532; 632; 732; 832; 932; 1032) umfasst, wobei der erste Bereich einen ersten Oberflächenbereich (121; 521; 621; 721; 821; 921; 1021) des Trägers und der zweite Bereich einen zweiten Oberflächenbereich (122; 722; 922) des Trägers abdeckt,
- Ablösen des zweiten Bereichs der Schicht von dem Träger, wobei der erste Bereich der Schicht auf dem ersten Oberflächenbereich des Trägers verbleibt und nicht von dem zweiten Bereich getrennt wird, wobei die Schicht im abgelösten zweiten Bereich biegsam ist,
wobei vor dem Herstellen der Schicht auf der Oberfläche des Trägers auf den zweiten Oberflächenbereich des Trägers eine haftkraftreduzierende Zwischenschicht aufgebracht wird, wobei der erste Oberflächenbereich ausgespart wird oder die haftkraftreduzierende Zwischenschicht von dem ersten Oberflächenbereich des Trägers wieder entfernt wird, bevor die Schicht auf der Oberfläche des Trägers hergestellt wird, wobei die haftkraftreduzierende Zwischenschicht aus nur einer Lage von Atomen oder der Molekülen eines Materials der haftkraftreduzierenden Zwischenschicht gebildet ist, und/oder
wobei vor dem Herstellen der Schicht auf der Oberfläche des Trägers auf den ersten Oberflächenbereich des Trägers eine haftkraftverstärkende Zwischenschicht aufgebracht wird, wobei der zweite Oberflächenbereich ausgespart wird oder die haftkraftverstärkende Zwischenschicht von dem zweiten Oberflächenbereich des Trägers wieder entfernt wird, bevor die Schicht auf der Oberfläche des Trägers hergestellt wird, wobei die haftkraftverstärkende Zwischenschicht aus nur einer Lage von Atomen oder der Molekülen eines Materials der haftkraftverstärkende Zwischenschicht gebildet ist.

2. Verfahren nach einem der vorangehenden Ansprüche, **dadurch gekennzeichnet, dass** der von dem Träger abgelöste zweite Bereich der Schicht gebogen oder gefaltet wird und/oder dass der von dem Träger abgelöste zweite Bereich mit einem weiteren Träger (715; 815) der Trägeranordnung verbunden wird.

3. Verfahren nach einem der vorangehenden Ansprüche, **dadurch gekennzeichnet, dass**, bevor oder nachdem der zweite Bereich der Schicht von dem Träger abgelöst wird, der Träger in dem zweiten Oberflächenbereich oder zwischen dem ersten Oberflächenbereich und dem zweiten Oberflächenbereich durchtrennt wird ohne den ersten Bereich der Schicht von dem zweiten Bereich der Schicht zu trennen.

4. Verfahren nach einem der vorangehenden Ansprüche, **dadurch gekennzeichnet, dass**, bevor der zweite Bereich der Schicht von dem Träger abgelöst wird, die Haftung des zweiten Bereichs der Schicht auf dem zweiten Oberflächenbereich reduziert wird, indem der zweite Oberflächenbereich des Trägers und/oder der auf dem zweiten Oberflächenbereich haftende zweite Bereich der Schicht durch den Träger hindurch mit elektromagnetischer Strahlung eines UV-Licht-Excimerlaser oder eines MidIR-Lasers bestrahlt wird und/oder dass der zweite Bereich der Schicht von dem Träger abgelöst wird, indem ein Bereich des Trägers, der den zweiten Oberflächenbereich des Trägers bildet, durch Ätzen entfernt wird.

5. Verfahren nach einem der vorangehenden Ansprüche, **dadurch gekennzeichnet, dass** der Träger ganz oder zumindest bereichsweise aus Silizium, Glas, Metall, Keramik und/oder einem Polymer gebildet ist und/oder dass der Träger ein Wafer, ein Teil eines Wafers, eine Platte oder ein Band ist und/oder dass die Schicht ganz oder zumindest bereichsweise eine aus einem Polymer, beispielsweise aus Polyimid oder Polybenzoxazol, aus einem Metall, aus Glas und/oder oder aus Silizium gebildet ist und/oder dass die Schicht eine Gesamtdicke zwischen 1 und 300 µm aufweist, vorzugsweise zwischen 1 und 100 µm und besonders bevorzugt zwischen 1 und 50 µm.

6. Verfahren nach einem der vorangehenden Ansprüche, **dadurch gekennzeichnet, dass** beim Herstellen der Schicht auf der Oberfläche des Trägers mindestens eine Isolationsschicht der Schicht aus einem elektrisch isolierenden Material gebildet wird, wobei die mindestens eine Isolationsschicht zumindest den ersten Oberflächenbereich und den zweiten Oberflächenbereich des Trägers abdeckt, wobei auf der mindestens einen Isolationsschicht eine Leitungsschicht aus einem elektrisch leitendenden Material gebildet wird, wobei die Leitungsschicht mindestens eine Leiterbahn umfasst.

7. Verfahren nach Anspruch 6, **dadurch gekennzeichnet, dass** die mindestens eine Leitungsschicht mindestens eine durchgängige Leiterbahn umfasst, die sich ausgehend von dem ersten Bereich der Schicht bis in den zweiten Bereich der Schicht erstreckt.

8. Verfahren nach einem der vorangehenden Ansprüche, **dadurch gekennzeichnet, dass** auf der Oberfläche des Trägers innerhalb des ersten Oberflächenbereichs mindestens ein elektrisches Kontaktelement angeordnet wird, wobei zwischen dem mindestens einen elektrischen Kontaktelement und mindestens einer Leiterbahn der Schicht eine elektrische Verbindung hergestellt wird.

9. Verfahren nach Anspruch 8, **dadurch gekennzeichnet, dass** das elektrische Kontaktelement ausgehend von dem ersten Oberflächenbereich des Trägers den ersten Bereich der Schicht teilweise oder vollständig durchläuft.

10. Verfahren nach einem der Ansprüche 8 oder 9, **dadurch gekennzeichnet, dass** das elektrische Kontaktelement mit einer auf dem Träger angeordneten Leiterbahn und/oder mit einem auf dem Träger angeordneten elektronischen Bauteil elektrisch leitend verbunden wird.

11. Verfahren nach einem der vorangehenden Ansprüche, **dadurch gekennzeichnet, dass** mindestens ein elektrisches Kontaktelement und/oder mindestens ein elektronisches Bauteil auf dem ersten Bereich und/oder auf dem zweiten Bereich der Schicht angeordnet oder in dem ersten Bereich und/oder in dem zweiten Bereich der Schicht integriert wird.

12. Trägeranordnung, umfassend:
- einen Träger mit einer Oberfläche und
- eine Schicht mit einem ersten Bereich, der auf einem ersten Oberflächenbereich (121) der Oberfläche des Trägers angeordnet ist, und einen mit dem ersten Bereich zusammenhängenden, biegsamen zweiten Bereich, der nicht auf der Oberfläche des Trägers angeordnet ist,
- eine haftkraftverstärkende Zwischenschicht, die aus nur einer Lage von Atomen oder der Molekülen eines Materials der haftkraftverstärkenden Zwischenschicht gebildet ist und die zwischen dem ersten Oberflächenbereich (121) des Trägers und dem ersten Bereich der Schicht angeordnet ist, und/oder eine haftkraftreduzierende Zwischenschicht, die aus nur einer Lage von Atomen oder der Molekülen eines Materials der haftkraftreduzierenden Zwischenschicht gebildet ist und die auf einem an den ersten Oberflächenbereich angrenzenden zweiten Oberflächenbereich des Trägers angeordnet ist.

13. Trägeranordnung nach Anspruch 12, **dadurch gekennzeichnet, dass** die Trägeranordnung zwischen der Oberfläche des Trägers und dem ersten Bereich der Schicht keine aus einem Kleber gebildete Schicht aufweist, insbesondere keine aus einem Kleber gebildete Schicht, die aus mehreren Lagen von Atomen oder Molekülen eines Materials des Klebers gebildet ist.

14. Trägeranordnung nach einem der Ansprüche 12 oder 13, **dadurch gekennzeichnet, dass** der zweite Bereich der Schicht über einen Rand des Trägers seitlich hinausragt und/oder dass eine von dem zweiten Bereich der Schicht definierte Ebene mit einer durch die Oberfläche des Trägers definierte Ebene einen nicht-verschwindenden Winkel einschließt, wobei der Winkel beispielsweise in einem Bereich zwischen 0° und 180° liegt, beispielsweise zwischen 85° und 95°.

15. Trägeranordnung nach einem der Ansprüche 12 bis 14, **dadurch gekennzeichnet, dass** die Trägeranordnung unter Anwendung eines Verfahrens nach einem der Ansprüche 1 bis 11 hergestellt worden ist.

## Claims

1. A method for producing a carrier arrangement (100; 500; 600; 700; 800; 900; 1000), comprising the following steps:
- producing a layer (130; 530; 630; 730; 830; 930; 1030) on a surface (120; 520; 620; 720; 820; 920; 1020) of a carrier (110; 510; 610; 710; 810; 910; 1010), the layer comprising a first region (131; 531; 631; 731; 831; 931; 1031) and a second region (132; 532; 632; 732; 832; 932; 1032) connected to the first region, the first region covering a first surface region (121; 521; 621; 721; 821; 921; 1021) of the carrier and the second region covering a second surface region (122; 722; 922) of the carrier,
- detaching the second region of the layer from the carrier, the first region of the layer remaining on the first surface region of the carrier and not being separated from the second region, the layer being flexible in the detached second region
wherein before the production of the layer on the surface of the carrier, an intermediate layer which reduces the adhesive force is applied on the second surface region of the carrier, wherein the first surface region is left out or the intermediate layer which reduces the adhesive force is removed from the first surface region of the carrier again before the layer is produced on the surface of the carrier,wherein the intermediate layer which reduces the adhesive force is formed from only one layer of atoms or the molecules of a material of the intermediate layer which reduces the adhesive force and/or
wherein before the production of the layer on the surface of the carrier, an intermediate layer which reinforces the adhesive force is applied on the first surface region of the carrier, wherein the second surface region is left out or the intermediate layer which reinforces the adhesive force is removed from the second surface region of the carrier again before the layer is produced on the surface of the carrier,wherein the intermediate layer which reinforces the adhesive force is formed from only one layer of atoms or the molecules of a material of the intermediate layer which reinforces the adhesive force.

2. The method according to any one of the preceding claims, **characterized in that** the second region of the layer detached from the carrier is bent or folded and/or the second region detached from the carrier is connected to a further carrier (715; 815) of the carrier arrangement.

3. The method according to any one of the preceding claims, **characterized in that**, before or after the second region of the layer is detached from the carrier, the carrier is severed in the second surface region or between the first surface region and the second surface region without separating the first region of the layer from the second region of the layer.

4. The method according to any one of the preceding claims, **characterized in that**, before the second region of the layer is detached from the carrier, the adhesion of the second region of the layer to the second surface region is reduced by irradiating the second surface region of the carrier and/or the second region of the layer adhering to the second surface region with electromagnetic radiation of a UV-light excimer laser or a MidIR laser through the carrier. and/or that the second region of the layer is detached from the carrier by removing by etching a region of the carrier which forms the second surface region of the carrier.

5. The method according to any one of the preceding claims, **characterized in that** the carrier is formed entirely or at least in regions from silicon, glass, metal, ceramic and/or a polymer, and/or that the carrier is a wafer, part of a wafer, a plate or a band, and/or the layer is entirely or at least in regions formed from a polymer, for example, from polyimide or polybenzoxazole, from a metal, from glass and/or from silicon, and/or that the layer has a total thickness between 1 and 300 µm, preferably between 1 and 100 µm and particularly preferably between 1 and 50 µm.

6. The method according to any one of the preceding claims, **characterized in that** during the production of the layer on the surface of the carrier, at least one insulating layer of the layer is formed from an electrically insulating material, wherein the at least one insulating layer covers at least the first surface region and the second surface region of the carrier, wherein a conductive layer made of an electrically conductive material is formed on the at least one insulating layer, wherein the conductive layer comprises at least one conductor track.

7. The method according to claim 6, **characterized in that** the at least one conductive layer comprises at least one continuous conductor track which, starting from the first region of the layer, extends into the second region of the layer.

8. The method according to any one of the preceding claims, **characterized in that** at least one electrical contact element is arranged on the surface of the carrier within the first surface region, wherein an electrical connection is established between the at least one electrical contact element and at least one conductor track of the layer.

9. The method according to claim 8, **characterized in that** the electrical contact element, starting from the first surface region of the carrier, partially or completely extends through the first region of the layer.

10. The method according to any one of claims 8 or 9, **characterized in that** the electrical contact element is connected in an electrically conductive manner to a conductor track arranged on the carrier and/or to an electronic component arranged on the carrier.

11. The method according to any one of the preceding claims, **characterized in that** at least one electrical contact element and/or at least one electronic component is arranged on the first region and/or on the second region of the layer or is integrated in the first region and/or in the second region of the layer.

12. A carrier arrangement, comprising:
- a carrier having a surface and
- a layer having a first region which is arranged on a first surface region (121) of the surface of the carrier and a flexible second region which is connected to the first region and which is not arranged on the surface of the carrier,
- an intermediate layer which reinforces the adhesive force, which intermediate layer is formed from only one layer of atoms or the molecules of a material of the intermediate layer which reinforces the adhesive force and which is arranged between the first surface region (121) of the carrier and the first region the layer, and/oran intermediate layer which reduces the adhesive force, which is formed from only one layer of atoms or the molecules of a material of the intermediate layer which reduces the adhesive force and which is arranged on a second surface region of the carrier adjoining the first surface region.

13. The carrier arrangement according to claim 12, **characterized in that** the carrier arrangement, between the surface of the carrier and the first region of the layer, does not have a layer formed from an adhesive, particularly no layer formed from an adhesive, which layer is formed from a plurality of layers of atoms or molecules of a material of the adhesive.

14. The carrier arrangement according to any one of claims 12 or 13, **characterized in that** the second region of the layer protrudes laterally beyond an edge of the carrier, and/or that a plane defined by the second region of the layer encloses a non-vanishing angle with a plane defined by the surface of the carrier, wherein the angle, for example, is in a range between 0° and 120°, for example, between 85° and 95°.

15. The carrier arrangement according to any one of claims 12 to 14, **characterized in that** the carrier arrangement has been produced using a method according to any one of claims 1 to 11.

## Revendications

1. Procédé de fabrication d'un ensemble de support (100 ; 500 ; 600 ; 700 ; 800 ; 900 ; 1000), comprenant les étapes ci-dessous consistant à :
- produire une couche (130 ; 530 ; 630 ; 730 ; 830 ; 930 ; 1030) sur une surface (120 ; 520 ; 620 ; 720 ; 820 ; 920 ; 1020) d'un support (110 ; 510 ; 610 ; 710 ; 810 ; 910 ; 1010), dans lequel la couche comprend une première région (131; 531 ; 631 ; 731 ; 831; 931 ; 1031) et une seconde région (132 ; 532 ; 632 ; 732 ; 832 ; 932 ; 1032) associée à la première région, dans lequel la première région recouvre une première région de surface (121 ; 521 ; 621 ; 721 ; 821 ; 921 ; 1021) du support et la seconde région recouvre une seconde région de surface (122 ; 722 ; 922) du support,
- détacher la seconde région de la couche d'avec le support, dans lequel la première région de la couche reste sur la première région de surface du support et n'est pas séparée de la seconde région, dans lequel la couche est flexible dans la seconde région détachée,
dans lequel, avant de produire la couche sur la surface du support, une couche intermédiaire réduisant l'adhérence est appliquée sur la seconde région de surface du support, dans lequel la première région de surface est laissée de côté ou la couche intermédiaire réduisant l'adhérence est à nouveau retirée de la première région de surface du support avant que la couche ne soit produite sur la surface du support, dans lequel la couche intermédiaire réduisant l'adhérence n'est constituée que d'une seule épaisseur d'atomes ou de molécules d'un matériau de la couche intermédiaire réduisant l'adhérence, et/ou
dans lequel, avant de produire la couche sur la surface du support, une couche intermédiaire renforçant l'adhérence est appliquée sur la première région de surface du support, dans lequel la seconde région de surface est laissée de côté ou la couche intermédiaire renforçant l'adhérence est à nouveau retirée de la seconde région de surface du support avant que la couche ne soit produite sur la surface du support, dans lequel la couche intermédiaire renforçant l'adhérence n'est constituée que d'une seule épaisseur d'atomes ou de molécules d'un matériau de la couche intermédiaire renforçant l'adhérence.

2. Procédé selon l'une quelconque des revendications précédentes, **caractérisé en ce que** la seconde région, détachée du support, de la couche est courbée ou pliée et/ou **en ce que** la seconde région détachée du support est reliée à un autre support (715 ; 815) de l'ensemble de support.

3. Procédé selon l'une quelconque des revendications précédentes, **caractérisé en ce que**, avant ou après le détachement de la seconde région de la couche d'avec le support, le support est séparé dans la seconde région de surface ou entre la première région de surface et la seconde région de surface sans séparer la première région de la couche d'avec la seconde région de la couche.

4. Procédé selon l'une quelconque des revendications précédentes, **caractérisé en ce que**, avant que la seconde région de la couche ne soit détachée du support, l'adhérence de la seconde région de la couche sur la seconde région de surface est réduite en irradiant, à travers le support, la seconde région de surface du support et/ou la seconde région de la couche adhérant à la seconde région de surface avec un rayonnement électromagnétique d'un laser excimère à lumière UV ou d'un laser Mid-IR et/ou **en ce que** la seconde région de la couche est détachée du support en retirant par abrasion une région du support qui forme la seconde région de surface du support.

5. Procédé selon l'une quelconque des revendications précédentes, **caractérisé en ce que** le support est formé en totalité ou au moins en partie de silicium, de verre, de métal, de céramique et/ou d'un polymère et/ou **en ce que** le support est une plaquette, une partie d'une plaquette, une plaque ou une bande et/ou **en ce que** la couche est formée en totalité ou au moins en partie d'un polymère, par exemple de polyimide ou de polybenzoxazole, d'un métal, de verre et/ou de silicium et/ou **en ce que** la couche présente une épaisseur totale comprise entre 1 et 300 µm, de manière préférée comprise entre 1 et 100 µm et de manière particulièrement préférée comprise entre 1 et 50 µm.

6. Procédé selon l'une quelconque des revendications précédentes, **caractérisé en ce que** lors de la production de la couche sur la surface du support, au moins une couche isolante de la couche est formée à partir d'un matériau électriquement isolant, dans lequel la au moins une couche isolante recouvrant au moins la première région de surface et la seconde région de surface du support, dans lequel une couche conductrice constituée d'un matériau électriquement conducteur est formée sur la au moins une couche isolante, dans lequel la couche conductrice comprend au moins une piste conductrice.

7. Procédé selon la revendication 6, **caractérisé en ce que** la au moins une couche conductrice comprend au moins une piste conductrice continue qui s'étend de la première région de la couche jusque dans la seconde région de la couche.

8. Procédé selon l'une quelconque des revendications précédentes, **caractérisé en ce qu'**au moins un élément de contact électrique est agencé sur la surface du support à l'intérieur de la première région de surface, dans lequel une connexion électrique est établie entre le au moins un élément de contact électrique et au moins une piste conductrice de la couche.

9. Procédé selon la revendication 8, **caractérisé en ce que** l'élément de contact électrique traverse partiellement ou complètement la première région de la couche à partir de la première région de surface du support.

10. Procédé selon la revendication 8 ou 9, **caractérisé en ce que** l'élément de contact électrique est relié de manière électriquement conductrice à une piste conductrice agencée sur le support et/ou à un composant électronique agencé sur le support.

11. Procédé selon l'une quelconque des revendications précédentes, **caractérisé en ce qu'**au moins un élément de contact électrique et/ou au moins un composant électronique est agencé sur la première région et/ou sur la seconde région de la couche ou est intégré dans la première région et/ou dans la seconde région de la couche.

12. Ensemble de support, comprenant :
- un support avec une surface et
- une couche comportant une première région agencée sur une première région de surface (121) de la surface du support, et comprenant une seconde région flexible qui est associée à la première région et n'est pas agencée sur la surface du support,
- une couche intermédiaire renforçant l'adhérence, qui est formée d'une seule épaisseur d'atomes ou de molécules d'un matériau de la couche intermédiaire renforçant l'adhérence et qui est agencée entre la première région de surface (121) du support et la première région de la couche, et/ou une couche intermédiaire réduisant l'adhérence, qui est formée d'une seule épaisseur d'atomes ou de molécules d'un matériau de la couche intermédiaire réduisant l'adhérence et qui est agencée sur une seconde région de surface du support adjacente à la première région de surface.

13. Ensemble de support selon la revendication 12, **caractérisé en ce que** l'ensemble de support ne présente pas de couche constituée d'un adhésif entre la surface du support et la première région de la couche, en particulier pas de couche constituée d'un adhésif et constituée de plusieurs épaisseurs d'atomes ou de molécules d'un matériau de l'adhésif.

14. Ensemble de support selon la revendication 12 ou 13, **caractérisé en ce que** la seconde région de la couche dépasse latéralement d'un bord du support et/ou **en ce qu'**un plan défini par la seconde région de la couche forme un angle non nul avec un plan défini par la surface du support, dans lequel l'angle est par exemple compris entre 0° et 120°, par exemple entre 85° et 95°.

15. Ensemble de support selon l'une quelconque des revendications 12 à 14, **caractérisé en ce que** l'ensemble de support a été fabriqué selon un procédé selon l'une quelconque des revendications 1 à 11.
